(19) Europäisches Patentamt / European Patent Office / Office européen des brevets

(11) **EP 2 393 110 A1**

(12) **EUROPEAN PATENT APPLICATION**
published in accordance with Art. 153(4) EPC

(43) Date of publication:
**07.12.2011 Bulletin 2011/49**

(51) Int Cl.:
*H01L 23/36* (2006.01)          *H01L 23/13* (2006.01)
*H05K 7/20* (2006.01)

(21) Application number: **10735894.7**

(22) Date of filing: **29.01.2010**

(86) International application number:
**PCT/JP2010/051211**

(87) International publication number:
**WO 2010/087432 (05.08.2010 Gazette 2010/31)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **29.01.2009   JP 2009017538**

(71) Applicants:
• **Okutec Co., Ltd.**
  **Sinjuku-ku, Tokyo 160-0011 (JP)**
• **Kyocera Corporation**
  **Kyoto-shi, Kyoto 612-8501 (JP)**

(72) Inventors:
• **OKUMURA, Katsuya**
  **Tokyo 160-0011 (JP)**
• **ABE, Yuichi**
  **Kirishima-shi**
  **Kagoshima 899-4396 (JP)**
• **NAKAMURA, Kiyotaka**
  **Kirishima-shi**
  **Kagoshima 899-4396 (JP)**
• **TANIGUCHI, Youhei**
  **Kirishima-shi**
  **Kagoshima 899-4396 (JP)**

(74) Representative: **Siegert, Georg**
  **Hoffmann · Eitle**
  **Patent- und Rechtsanwälte**
  **Arabellastraße 4**
  **81925 München (DE)**

(54) **HEAT DISSIPATING BASE BODY AND ELECTRONIC DEVICE USING SAME**

(57)    Provided is a heat radiation base body having excellent heat radiation characteristics, in which, first metal layers 31 and 32 containing at least one metal element selected from titanium, zirconium, hafnium, and niobium; heat conductive layers 41 and 42 containing carbon as main components; and second metal layers 51 and 52 are sequentially laminated on at least one major surface of a support substrate 21 made of a ceramics from the support substrate side 21. There is also provided an electronic device in which an electronic part is mounted on the second metal layer 51 arranged on a first major surface side in the heat radiation base body 1.

Fig.1

**Description**

Technical Field

The present invention relates to a heat radiation base body and an electronic device in which an electronic part is mounted.

Background Art

In recent years, electronic devices in which various electronic parts such as an insulating gate bipolar transistor (IGBT) element, a metal oxide film field effect transistor (MOSFET) element, a light emitting diode (LED) element, a free wheeling diode (FWD) element, a giant transistor (GTR) element, a semiconductor element such as a peltier element, a sublimation type thermal printer head element, and a thermal ink-jet printer head element are mounted on a circuit member of a heat radiation base body are used.

In recent years, as a heat radiation base body obtained by arranging a circuit member having an electronic part mounted thereon, like a ceramic circuit substrate and a ceramics-metal junction disclosed in Patent Documents 1 and 2, a heat radiation base body in which a metal such as copper or aluminum having a low electric resistance and a high heat conductivity is directly, or through a brazing filler metal, bonded to a ceramic substrate having electric insulativity and being good in heat conductivity and mechanical strength is generally used.

FIG. 17 is a sectional view showing an example of a ceramic circuit substrate proposed in Patent Document 1. The ceramic circuit substrate 80 is obtained such that copper plates 82 and 83 serving as conductive layers are brought into contact with and arranged on both the surfaces of a ceramic substrate 81 serving as an insulating member, a semiconductor element 86 is integrally bonded to, through a soldering layer 85, the copper plate 82 serving as a conductive layer of a metalized substrate 84 by using, as a bonding agent, an eutectic compound between copper and oxygen generated by heating, and the surface of the copper plate 83 serving as a conductive layer of the metalized substrate 84 opposing a side to which the semiconductor element 86 is bonded is integrally bonded to a heat radiation plate 88 with a heat conductive adhesive agent 87. The semiconductor element 86 is wire-bonded such that the copper plate 82 and the semiconductor element 86 are connected by using an Al lead wire 89.

In Patent Document 2, there is proposed a ceramics-metal junction including a metal member bonded to a nitride-based ceramic member through an Ag-Cu-based brazing filler metal layer containing a nitride-based ceramic member and an active metal of at least one type selected from Ti, Zr, and Nb, wherein layers in which active metals are segregated are continuously present on a junction interface on a nitride-based ceramic member side.

However, the ceramic circuit substrate 80 that is a heat radiation base body proposed in Patent Document 1 is obtained by bonding the ceramic substrate 81 and the copper plates 82 and 83 at a high temperature of 1065°C or more to 1083°C or less. For this reason, the thicknesses of the copper plates 82 and 83 that can be bonded are limited. It is not true that the copper plates 82 and 83 have sufficient heat discharge characteristic with respect to a recent highly integrated semiconductor element. Furthermore, at outer peripheral portions of the copper plates 82 and 83, the ceramic substrate 81 is strongly restrained. For this reason, the ceramic circuit substrate 80 may be largely warped.

The ceramics-metal junction proposed in Patent Document 2 is integrally bonded to a nitride-based ceramic member through a brazing filler metal layer having a metal member containing an active metal while being heated to an Ag-Cu eutectic temperature (780°C) or higher. For this reason, when the metal member is thickened, due to a difference between linear expansion coefficients of the nitride-based ceramic member and the metal member, large tensile stress acts on the nitride-based ceramic member, and the nitride-based ceramic member may be considerably warped.

[Patent Document 1] Unexamined Japanese Patent Publication No. 5-90444
[Patent Document 2] Unexamined Japanese Patent Publication No. 5-148053

Disclosure of the Invention

Problem to be Solved by the Invention

It is an object of the present invention to solve the above problems and to provide a heat radiation base body with good heat discharge characteristic in which a support substrate made of a ceramics is not easily warped even though the heat radiation base body is entirely thickened and an electronic device using the heat radiation base body.

Means for Solving the Problem

A heat radiation base body according to an embodiment of the present invention is formed by sequentially laminating, on at least one major surface of a support substrate composed of a ceramics, from the support substrate side, a first metal layer containing at least one metal element selected from titanium, zirconium, hafnium, and niobium, a heat conductive layer containing carbon as a main component, and a second metal layer.
In an electronic device according to an embodiment of the present invention, an electronic part is mounted on the second metal layer arranged on the first major surface side on the heat radiation base body.

Effect of the Invention

According to a heat radiation base body according to an embodiment of the present invention, since a difference between the linear expansion coefficients of a support substrate and a heat conductive layer can be decreased, warp occurring in the support substrate decreases. When the warp occurring in the support substrate decreases, thick heat conductive layers can be arranged on both the major surfaces of the support substrate, and a heat discharge characteristic can be improved. Since the electronic part generates heat during an operation, a heat sink to cool the electronic part is generally attached. However, the use of the heat sink can be eliminated.
Furthermore, according to an electronic part according to an embodiment of the present invention, since a heat radiation base body has a high heat discharge characteristic even in an operation of an electronic part, heat can be suppressed from being accumulated in the electronic part, and a preferable electronic device can be obtained.

Brief Description of the Drawings

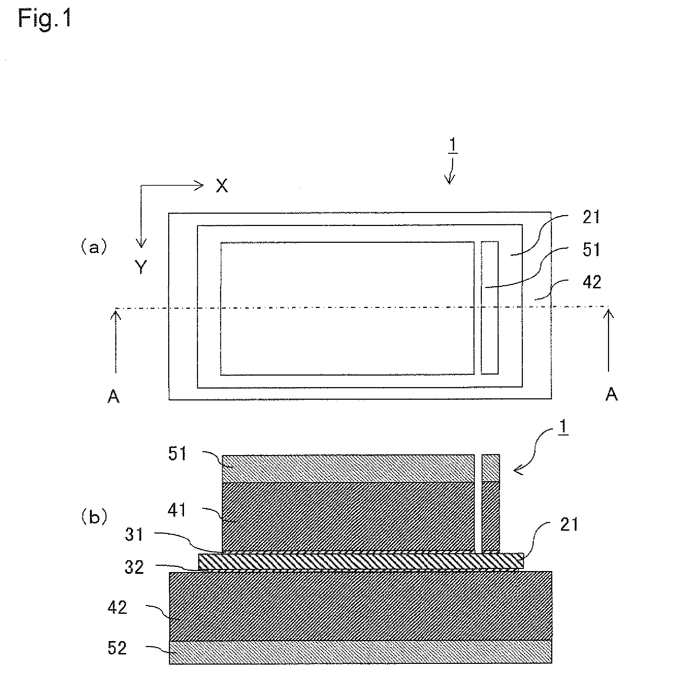

[FIG. 1] FIG. 1 is a diagram for explaining an embodiment of a heat radiation base body according to the present invention. FIG. 1(a) is a plan view and FIG. 1(b) is a sectional view along an A - A line in FIG. 1(a).

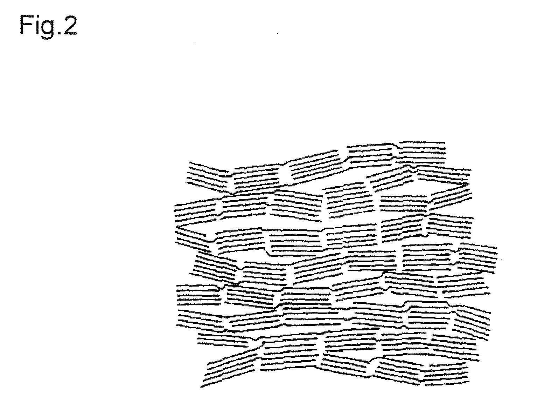

[FIG. 2] FIG. 2 is a pattern diagram showing a preferable crystal structure of graphite.

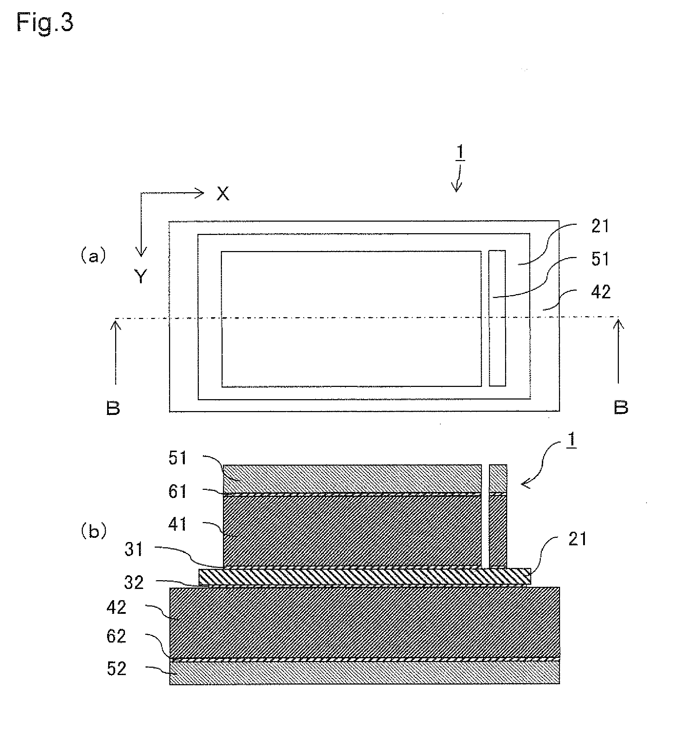

[FIG. 3] FIG. 3 is a diagram for explaining another embodiment of the heat radiation base body according to the present invention. FIG. 3(a) is a. plan view and FIG. 3(b) is a sectional view along a B - B line in FIG. 3(a).

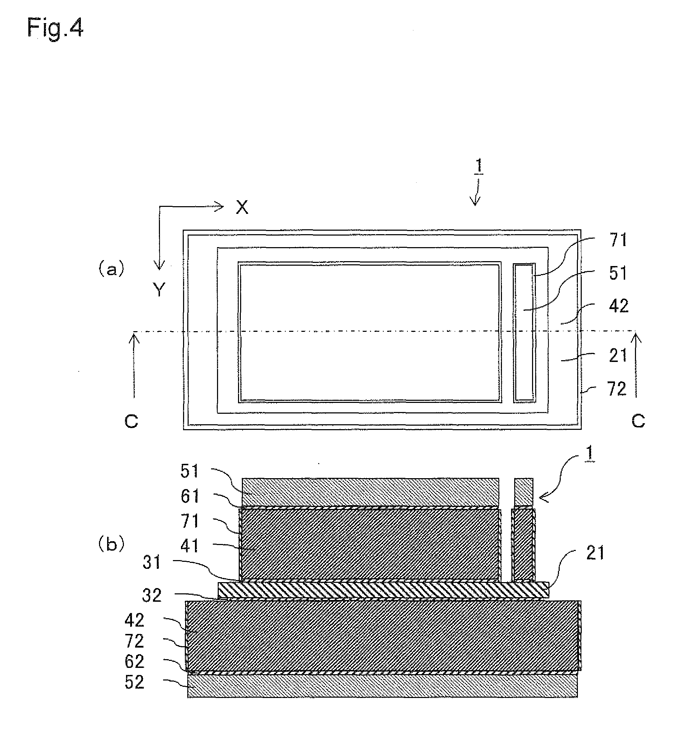

[FIG. 4] FIG. 4 is a diagram for explaining still another embodiment of the heat radiation base body according to the present invention. FIG. 4(a.) is a plan view and FIG. 4(b) is a sectional view along a C - C line in FIG. 4(a).

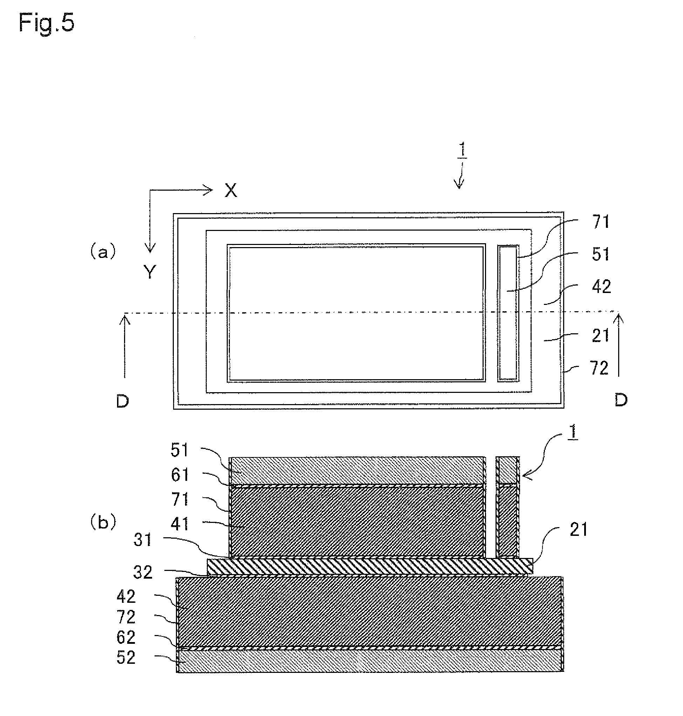

[FIG. 5] FIG. 5 is a diagram for explaining still another embodiment of the heat radiation base body according to the present invention. FIG. 5(a) is a plan view and FIG. 5(b) is a sectional view along a D - D line in FIG. 5(a).

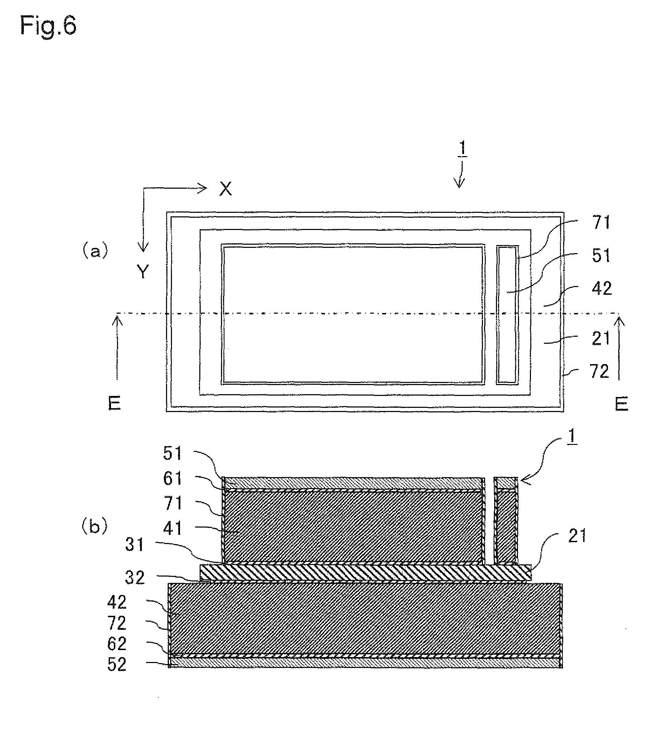

[FIG. 6] FIG. 6 is a diagram for explaining still another embodiment of the heat radiation base body according to the present invention. FIG.6(a) is a plan view and FIG. 6(b) is a sectional view along an E - E line in FIG. 6(a).

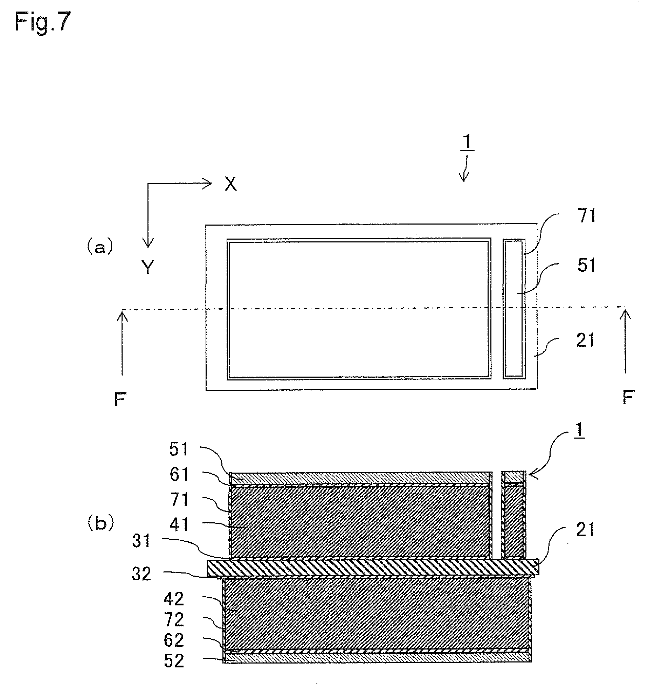

[FIG. 7] FIG. 7 is a diagram for explaining still another embodiment of the heat radiation base body according to the present invention. FIG. 7(a) is a plan view and FIG. 7(b) is a sectional view along an F - F line in FIG. 7(a).

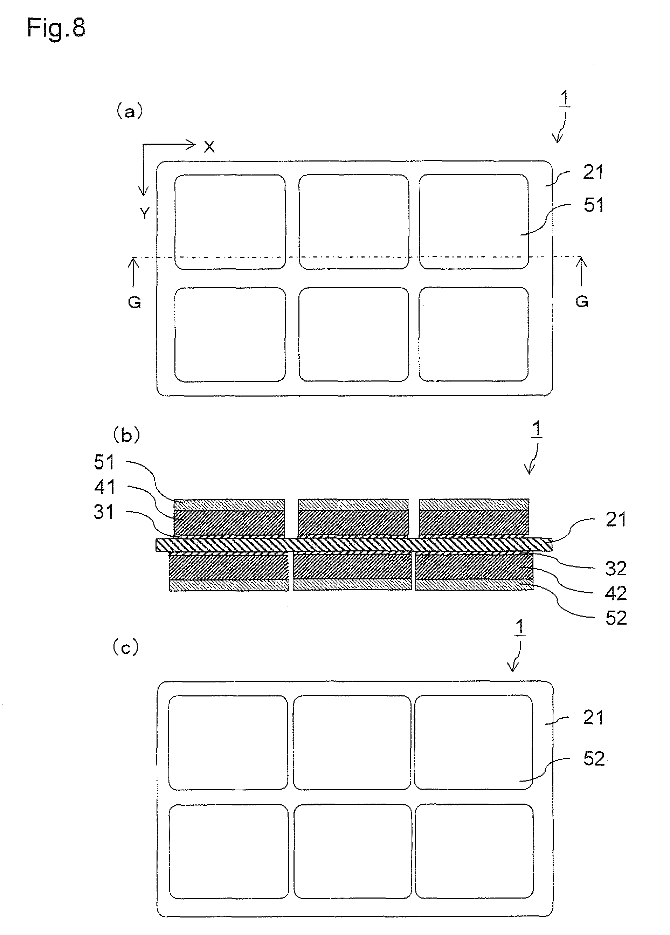

[FIG. 8] FIG. 8 is a diagram for explaining still another embodiment of a. heat radiation base body according to the present invention. FIG. 8(a) is a plan view obtained when a support substrate is planarly-viewed from a first major surface side, FIG. 8(b) is a sectional view along a G - G line in FIG. 8(a), and FIG. 8(c) is a bottom view obtained when a support substrate is planarly viewed from a second major surface side.

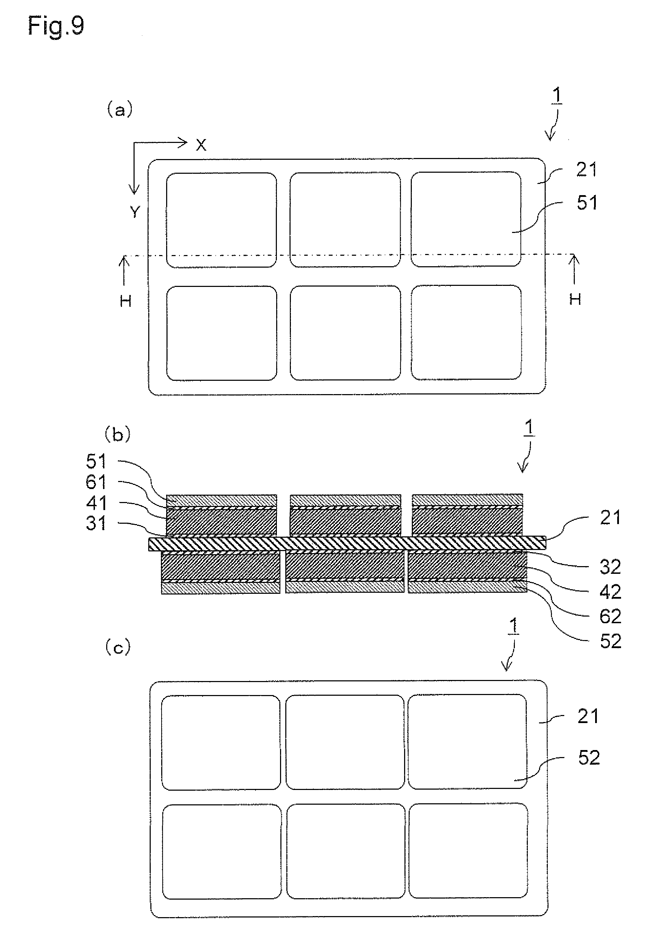

[FIG. 9] FIG. 9 is a diagram for explaining still another embodiment of a heat radiation base body according to the present invention. FIG. 9(a) is a plan view obtained when a support substrate is planarly viewed from a first major surface side, FIG. 9(b) is a sectional view along an H - H line in FIG. 9(a), and FIG. 9(c) is a bottom view obtained when a support substrate is planarly viewed from a second major surface side.

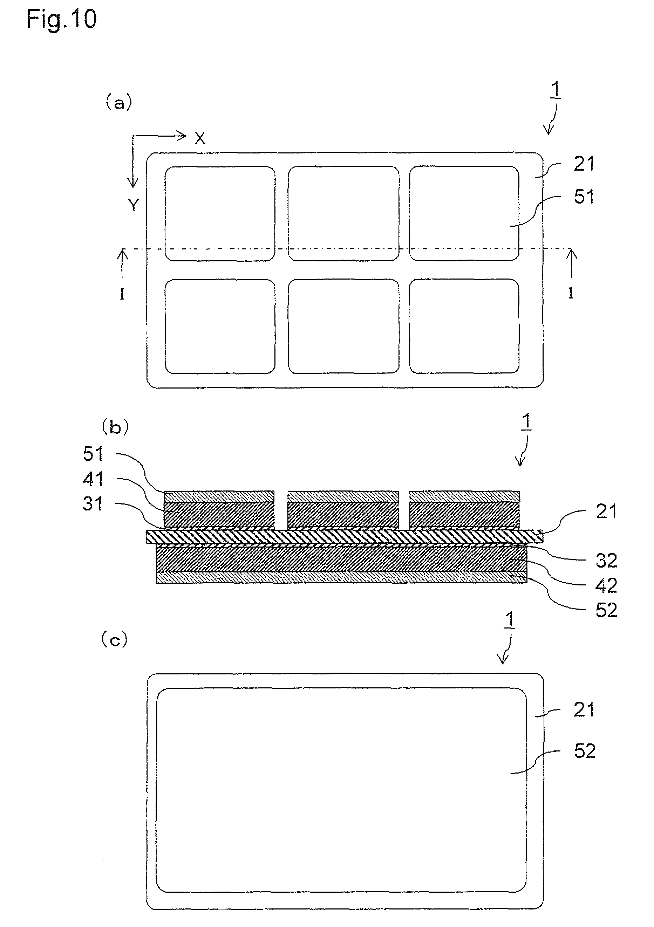

[FIG. 10] FIG. 10 is a diagram for explaining still another embodiment of a heat radiation base body according to the present invention. FIG. 10(a) is a plan view obtained when a support substrate is planarly viewed from a first major surface side, FIG. 10(b) is a sectional view along an I - I line in FIG. 10(a), and FIG. 10(c) is a bottom view obtained when a support substrate is planarly viewed from a second major surface side.

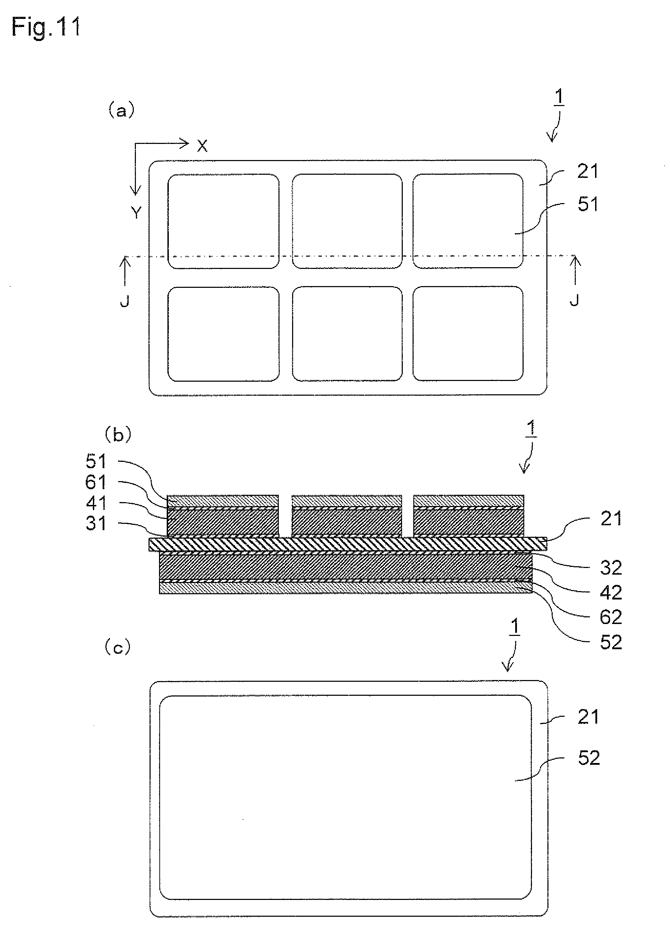

[FIG. 11] FIG. 11 is a diagram for explaining still another embodiment of a heat radiation base body according to the present invention. FIG. 11(a) is a plan view obtained when a support substrate is planarly viewed from a first major surface side, FIG. 11(b) is a sectional view along a J - J line in FIG. 11(a), and FIG. 11(c) is a bottom view obtained when a support substrate is planarly viewed from a second major surface side.

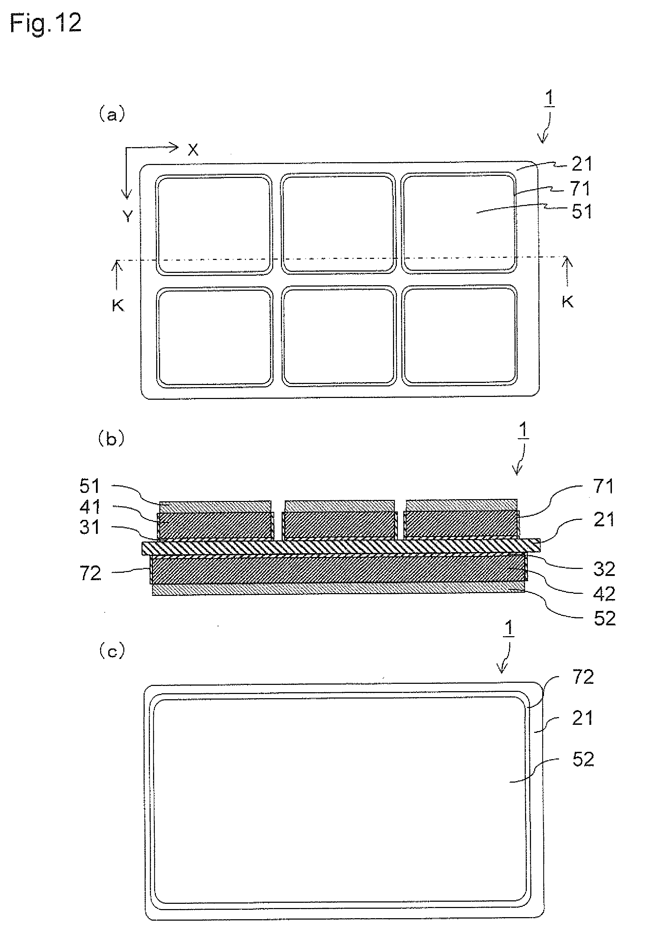

[FIG. 12] FIG. 12 is a diagram for explaining still another embodiment of a heat radiation base body according to the present invention. FIG. 12(a) is a plan view obtained when a support substrate is planarly viewed from a first major surface side, FIG. 12(b) is a sectional view along a K - K line in FIG. 12(a), and FIG. 12(c) is a bottom view obtained when a support substrate is planarly viewed from a second major surface side.

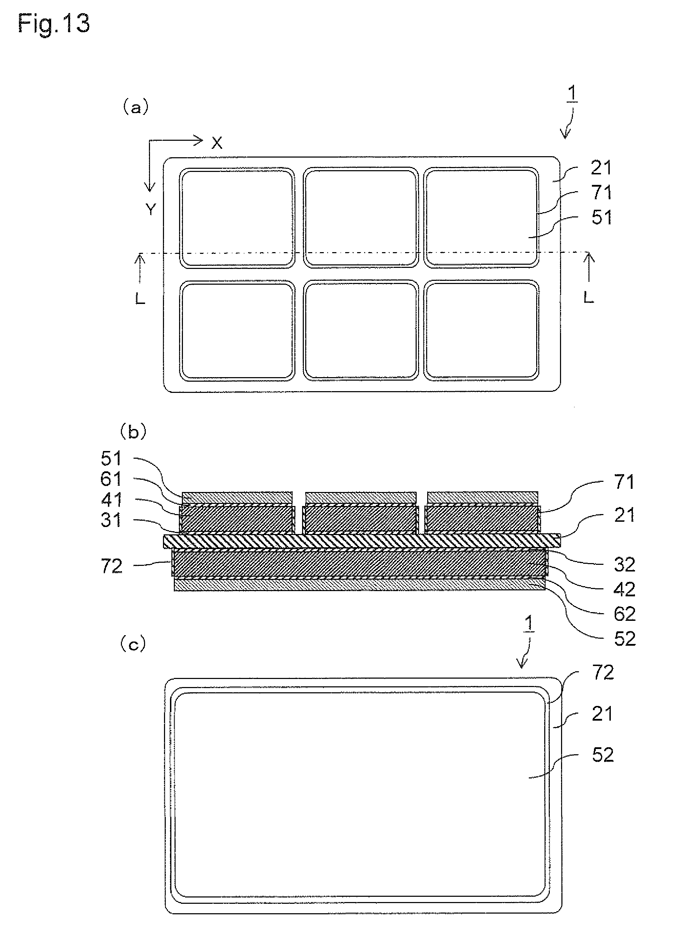

[FIG. 13] FIG. 13 is a diagram for explaining still another embodiment of a heat radiation base body according to the present invention. FIG. 13(a) is a plan view obtained when a support substrate is planarly viewed from a first major surface side, FIG. 13(b) is a sectional view along an L - L line in FIG. 13(a), and FIG. 13(c) is a bottom view obtained when a support substrate is planarly viewed from a second major surface side.

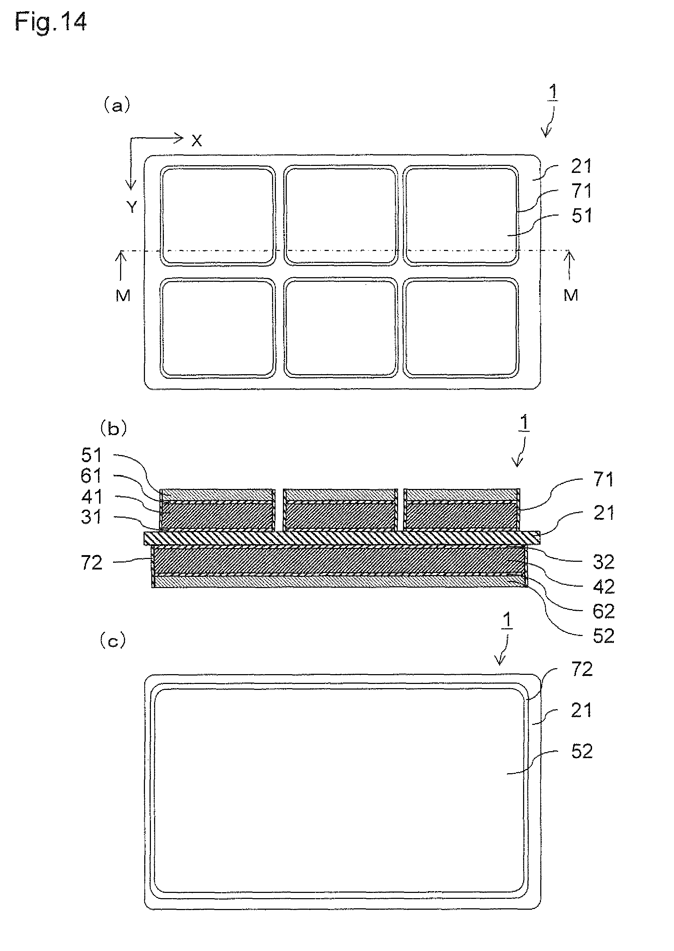

[FIG. 14] FIG. 14 is a diagram for explaining still another embodiment of a heat radiation base body according to the present invention. FIG. 14(a) is a plan view obtained when a support substrate is planarly viewed from a first major surface side, FIG. 14(b) is a sectional view along an M - M line in FIG. 14(a), and FIG. 14(c) is a bottom view obtained when a support substrate is planarly viewed from a second major surface side.

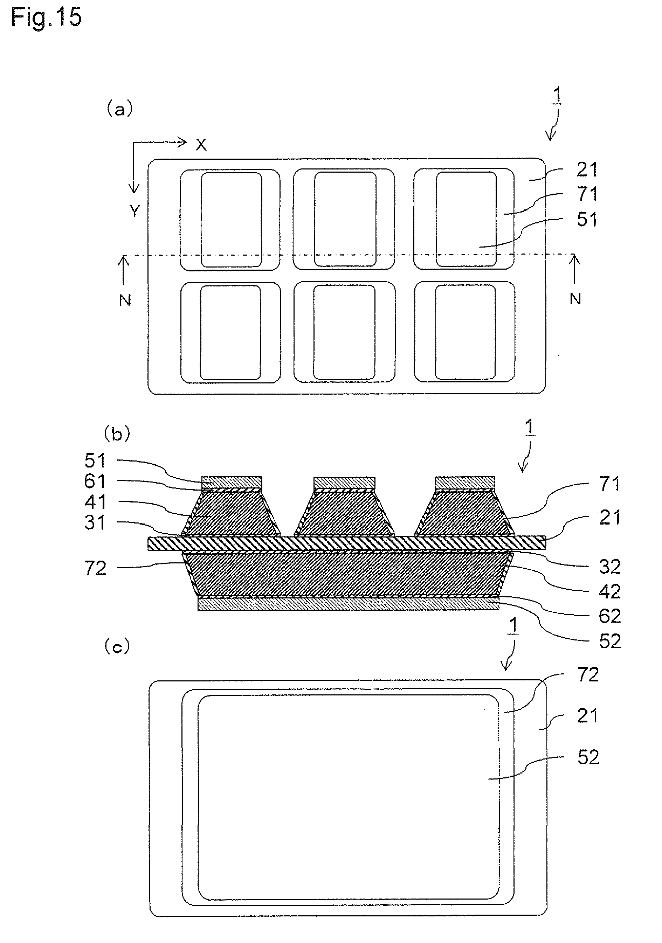

[FIG. 15] FIG. 15 is a diagram for explaining still another embodiment of a heat radiation base body according to the present invention. FIG. 15(a) is a plan view obtained when a support substrate is planarly viewed from a first major surface side, FIG. 15(b) is a sectional view along an N - N line in FIG. 15(a), and FIG. 15(c) is a bottom view obtained when a support substrate is planarly viewed from a second major surface side.

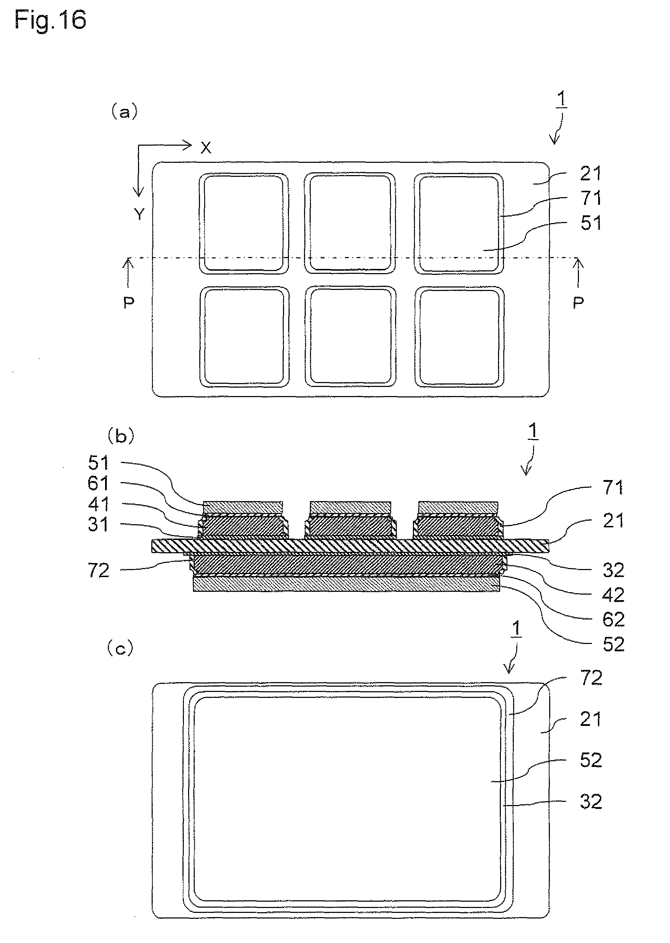

[FIG. 16] FIG. 16 is a diagram for explaining still another embodiment of a heat radiation base body according to the present invention. FIG. 16(a) is a plan view obtained when a support substrate is planarly viewed from a first major surface side, FIG. 16(b) is a sectional view along a P - P line in FIG. 16(a), and FIG. 16(c) is a bottom view obtained when a support substrate is planarly viewed from a second major surface side.

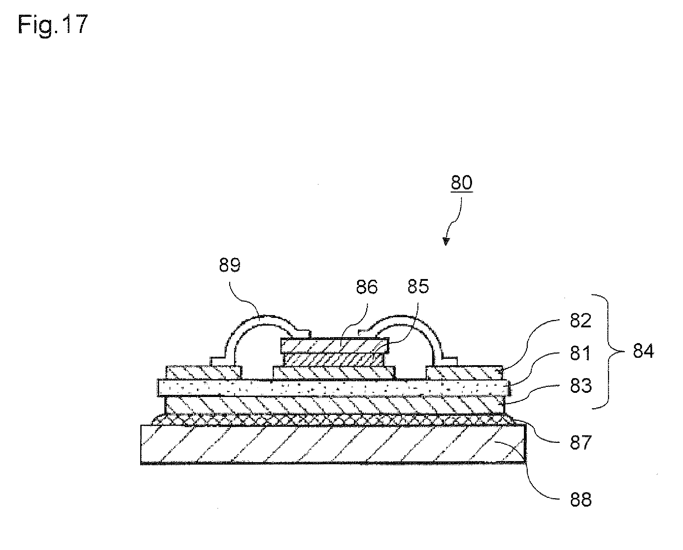

[FIG. 17] FIG. 17 is a sectional view showing another example of a conventional heat radiation base body.

Mode for Carrying out the Invention

A mode for carrying out the present invention will be described below with reference to the accompanying drawings. The same reference symbols as in the drawings denote the same parts in the drawings.

<First Embodiment>

As shown in FIG. 1, in a heat radiation base body 1 according to the embodiment, on both the major surfaces of a support substrate 21 composed of a ceramics, from a support substrate 21 side, first metal layers 31 and 32, heat conductive layers 41 and 42 containing carbon as main components, and second metal layers 51 and 52 are sequentially laminated. The laminated structure may be formed on at least one major surface of the support substrate 21. The first metal layers 31 and 32 may contain at least one metal element selected from titanium, zirconium, hafnium, and niobium. In this manner, the support substrate 21 and the heat conductive layers 41 and 42 can be strongly bonded through the first metal layers 31 and 32. The first metal layers 31 and 32 more preferably contain silver or copper as main components (to be referred to as a "main component" in a certain layer is a component of 50% by weight or more with reference to 100% by weight of all components constituting the layer).

Furthermore, when the main components of the first metal layers 31 and 32 are copper, the main components of the second metal layers 51 and 52 are preferably silver or copper. When the main components of the first metal layers 31 and 32 are silver, the main components of the second metal layers 51 and 52 are preferably copper or aluminum. When the second metal layers 51 and 52 contain silver, copper, or aluminum as main components, the heat discharge characteristic of the heat radiation base body 1 can be more improved because all silver, copper, and aluminum have high heat conductivities.

The second metal layers 51 and 52 may contain tungsten or molybdenum as main components when the main components of the first metal layers 31 and 32 are silver or copper. When the main components of the second metal layers 51 and 52 are tungsten or molybdenum, since differences between both the linear expansion coefficients of tungsten and molybdenum and the linear expansion coefficients of the ceramics constituting the support substrate 21 and the carbon constituting the heat conductive layers 41 and 42 are small, an electronic part (not shown) such as a semiconductor element is mounted on any one of the second metal layers 51 and 52. A residual stress remaining in the support substrate 21 decreases due to heat generated during the operation of the electronic part to make it possible to reduce the warp occurring in the support substrate 21. For this reason, the reliability is not easily damaged.

The first metal layers 31 and 32 are preferably composed of a silver-copper-based alloy containing at least one metal element selected from titanium, zirconium, hafnium, and niobium. This is because the alloy is heated and melted at a high temperature of 780°C or more to 900°C or less in a pressured state between the support substrate 21 and the heat conductive layers 41 and 42 to make the alloy to follow the uneven major surfaces of the support substrate 21 and the heat conductive layers 41 and 42 on the junction sides and to make it possible to strongly bond the support substrate 21 and the heat conductive layers 41 and 42 by cooling the alloy thereafter.

Furthermore, the first metal layers 31 and 32 preferably contain at least one metal element selected from indium and tin. This is because, when the support substrate 21 and the heat conductive layers 41 and 42 are bonded to each other, since the metal elements having a low melting point is contained, paste-like brazing filler metals serving as the first metal layers 31 and 32 easily follow the uneven major surfaces of the support substrate 21 and the heat conductive layers 41 and 42 on the junction sides, whereby voids remaining in the first metal layers 31 and 32 decrease to improve the heat discharge characteristic of the heat radiation base body 1.

In particular, the first metal layers 31 and 32 are composed of a silver-copper alloy containing at least metal element selected from titanium, zirconium, hafnium, and niobium, for example, the silver-copper alloy preferably containing 45% by weight or more to 58% by weight or less of silver, 40% by weight or more to 50% by weight or less of copper, a total of 1.5% by weight or more to 6.0% by weight or less of at least one metal element selected from titanium, zirconium, hafnium, and niobium, and a total of 1% by weight or more to 5% or less of at least one metal element selected from indium and tin and preferably having a thickness of 10 $\mu$m or more to 30 $\mu$m or less.

In this case, the support substrate 21 is composed of, for example, a ceramics containing, as a main component, at least one selected from a silicon nitride, an aluminum nitride, an aluminum oxide, a beryllium oxide, and a zirconium oxide. In particular, the support substrate 21 preferably has, for example, a length in an X direction of 20 mm or more to 200 mm or less, a length in a Y direction of 10 mm or more to 200 mm or less, and a thickness changing depending on applications. In order to obtain high endurance, a high withstand voltage, and a suppressed heat resistance, the thickness is preferably 0.2 mm or more to 1.0 mm or less.

The main component in the ceramics is a component having 50% by weight or more with reference to 100% by weight of all components constituting the ceramics. With respect to the support substrate 21, the first metal layers 31 and 32, and the second metal layers 51 and 52, contents can be known by a fluorescent X-ray analysis or an ICP (Inductively Coupled Plasma) emission spectral analysis. The contents of the main components of the heat conductive layers 41 and 42 can be known by a carbon analysis.

In this case, a linear expansion coefficient of the ceramics constituting the support substrate 21 at 40 to 400°C, for example, $2.6 \times 10^{-6}$/°C or more to $7.2 \times 10^{-6}$/°C or less. A linear expansion coefficient of carbon that is the main component of the heat conductive layers 41 and 42 at 40 to 400°C, for example, $1.1 \times 10^{-6}$/°C or more to $6.5 \times 10^{-6}$/°C or less.

In this manner, according to the configuration of the heat radiation base body 1 of the present invention, even though the support substrate 21 and the heat conductive layers 41 and 42 are exposed to a high temperature, a difference between the linear expansion coefficient of the ceramics constituting the support substrate 21 and the linear expansion coefficient of the carbon that is the main components of the heat conductive layers 41 and 42 is small. For this reason, thermal stress generated in the heat radiation base body 1 can be reduced. As a result, residual stress remaining in the heat radiation base body 1 becomes small, and the heat radiation base body 1 having small warp can be obtained. In addition, since the thicknesses of the heat conductive layers 41 and 42 can be increased to 0.5 mm or more to 10.0 mm or less, the heat radiation base body 1 having an excellent heat discharge characteristic can be obtained. Depending on the cases, a heat sink (not shown) to cool an electronic part or the like mounted on the heat radiation base body 1 need not be attached. Since a silicone resin generally used to attach the heat sink is also unnecessary, a heat resistance caused by the silicone resin is not generated, and the heat discharge characteristic of the heat radiation base body 1 can be improved.

The side surfaces of the first metal layers 31 and 32 preferably is positioned in the outer sides of the side surfaces of the heat conductive layers 41 and 42. When the side surfaces of the first metal layers 31 and 32 are located at the positions, stress acting on the support substrate 21 is dispersed, and the heat radiation base body 1 having high endurance can be obtained. In particular, the side surfaces of the first metal layers 31 and 32 preferably is positioned in the outer sides of the side surfaces of the heat conductive layers 41 and 42 within 150 $\mu$m.

Each of the heat conductive layers 41 and 42 preferably has, for example, a length in an X direction of 5 mm or more to 120 mm or less, a length in a Y direction of 5 mm or more to 100 mm or less, and a thickness determined depending on a magnitude of a current flowing in an electronic part, a heat value generated by the electronic part, and the like, and desirably set to 0.5 mm or more to 10.0 mm or less. Carbon constituting the heat conductive layers 41 and 42 is preferably, for example, carbon nanotube, a carbon fiber, graphene, graphite, amorphous carbon, a carbon fiber reinforced plastic (CFRP), or diamond.

A case in which graphite is selected as the carbon constituting the heat conductive layers 41 and 42 will be described below. A crystal structure of graphite influences cavities in crystal particles of graphite. When the crystal structure of graphite, as shown in FIG. 2, is a structure in which a carbon layer surface exhibits orderly orientation, the number of cavities in crystal particles of graphite decreases. For this reason, compressive strengths of the heat conductive layers 41 and 42 can be improved.

When the carbon constituting the heat conductive layers 41 and 42 included in the heat radiation base body 1 according to the embodiment is graphite, a half bandwidth from a (002) plane obtained by a measurement using an X-ray diffraction method is preferably set to 0.3° or less (except for 0°). The crystal structure of graphite is the structure shown in FIG. 2, and mechanical characteristics typified by a compressive strength, for example, a bending strength, Young's modulus, a hardness, and the like can be increased.

In particular, the crystal structure of graphite is preferably a hexagonal crystal structure called 2H graphite. The heat conductive layers 41 and 42 may be made of combined materials obtained by using carbon as an aggregate and impregnating the carbon with a metal, for example, copper or aluminum.

Each of the second metal layers 51 and 52 preferably has, for example, a length in an X direction of 5 mm or more to 120 mm or less, a length in a Y direction of 5 mm or more to 100 mm or less, and a thickness changing depending on currents flowing in the electronic part. The thickness is preferably set to 0.1 mm or more to 0.5 mm or less.

The measurement of the dimensions may be performed by any one method selected from a contact measurement, a contactless laser dislocation measurement, and the like.

The other embodiments of the present invention will be described below. However, a detailed explanation of the same configuration as that in the first embodiment will be omitted.

<Second Embodiments

The heat radiation base body 1, as shown in FIG. 3, may be obtained by forming intermediate layers 61 and 62 between the heat conductive layers 41 and 42 and the second metal layers 51 and 52. The intermediate layers 61 and 62 preferably contain at least one metal element selected from chromium, manganese, cobalt, iron, cobalt, and nickel as a main component. When the intermediate layers 61 and 62 contain the metal elements as main components, since the metal element has a high adhesion to carbon, silver, copper, aluminum, tungsten, and molybdenum, bond strengths between the heat conductive layers 41 and 42 and the second metal layers 51 and 52 can be increased. An electronic part such as a semiconductor element is mounted on any one of the second metal layers 51 and 52, and heat generated during an operation of the electronic part makes it hard to peel the second metal layers 51 and 52. For this reason, the reliability can be improved. The thicknesses of the intermediate layers 61 and 62 are preferably set to 0.1 $\mu$m or more to 20 $\mu$m or less.

Although not shown, the heat radiation base body 1 may be obtained by forming intermediate layers between the heat conductive layers 41 and 42 and the first metal layers 31 and 32. The intermediate layers, like the intermediate layers 61 and 62, preferably contain at least one metal element selected from chromium, manganese, iron, cobalt, and nickel as a main component.

When the intermediate layers contain the metal elements as main components, since the metal element has a high adhesion to carbon, silver, and copper, bond strengths between the heat conductive layers 41 and 42 and the first metal layers 31 and 32 can be increased. An electronic part such as a semiconductor element is mounted on any one of the second metal layers 51 and 52, and heat generated during an operation of the electronic part makes it hard to peel the heat conductive layers 41 and 42. For this reason, the reliability can be improved. The thicknesses of the intermediate layers are preferably set to 0.1 $\mu$m or more to 20 $\mu$m or less.

Components of the intermediate layers 61 and 62 and the intermediate layers formed between the heat conductive layers 41 and 42 and the first metal layers 31 and 32 can be known by a fluorescent X-ray analysis or an ICP emission spectral analysis. Contents of the metal elments serving as the main components that make the second metal layers 51 and 52 are preferably 99.9% by weight or more.

In the heat radiation base body 1, the heat conductive layers 41 and 42 are made of carbonaceous sintered bodies. The carbonaceous sintered base body preferably has a relative density of 80% or more. In this case, the heat conductive layers 41 and 42 can have high strength and high heat conductivity for the heat conductive layers 41 and 42.

<Third Embodiment>

The heat radiation base body 1 shown in FIG 4 is the heat radiation base body 1 in which covering layers 71 and 72 composed of a silver-copper alloy containing at least one metal element selected from titanium, zirconium, hafnium, and niobium are formed on the side surfaces of the heat conductive layers 41 and 42.

<Fourth Embodiment>

The heat radiation base body 1 shown in FIG. 5 is the heat radiation base body 1 in which the covering layers 71 and 72 composed of at least one metal element selected from gold, copper, aluminum, tin, and zinc are formed on the side surfaces of the heat conductive layers 41 and 42 and the second metal layers 51 and 52. The metal elements may be mutually diffused to form an alloy.

In the heat radiation base bodys 1 according to the third and fourth embodiments, moisture in the air is not easily absorbed by the heat conductive layers 41 and 42. Even though the moisture in the air is absorbed by the heat conductive layers 41 and 42, the vapor is suppressed by the covering layers 71 and 72. For this reason, the first metal layers 31 and 32 and the second metal layers 51 and 52 are not easily corroded, and the reliability can be improved. The thickness of each of the covering layers 71 and 72 is preferably 20 $\mu$m or more to 200 $\mu$m or less.

<Fifth Embodiment>

The heat radiation base body 1 shown in FIG. 6 is the heat radiation base body 1 in which the thickness of each of the second metal layers 51 and 52 is 30% or less the thickness of each of the heat conductive layers 41 and 42. In the heat radiation base body 1, since thermal stress generated in the bonding step decreases due to the differences between the linear expansion coefficients of the heat conductive layers 41 and 42 and the second metal layers 51 and 52, warp occurring in the support substrate 21 of the heat radiation base body 1 is smaller than that in the heat radiation base body 1 in which the thickness of each of the second metal layers 51 and 52 is larger than 30% the thickness of each of the heat conductive layers 41 and 42. An electronic part such as a semiconductor element is mounted on any one of the second metal layers 51 and 52, and the reliability is not easily damaged by heat generated during an operation of the electronic part.

<Sixth Embodiment>

The heat radiation base body 1 shown in FIG. 7 is the heat radiation base body 1 in which the side surfaces on the outer sides of the first metal layers 31 and 32 and the heat conductive layers 41 and 42 are on the inside of the side surface of the support substrate 21. In the heat radiation base body 1, in comparison with the case in which the side surfaces of the first metal layers 31 and 32, the heat conductive layers 41 and 42, and the support substrate 21 are on the same plane, the side surfaces of the heat conductive layers 41 and 42 and the second metal layers 51 and 52 are strongly restrained. For this reason, the heat conductive layers 41 and 42 and the second metal layers 51 and 52 are not easily deformed. As a result, since stress generated in the support substrate 21 is also suppressed by heat generated during an operation of the electronic part, the reliability of the heat radiation base body 1 is improved.

<Seventh Embodiment>

The heat radiation base body 1 shown in FIG. 8 is the heat radiation base body 1 in which the first metal layers 31 and 32, the heat conductive layers 41 and 42, and the second metal layers 51 and 52 are sequentially laminated on the first major surface of the support substrate 21 and a second major surface on the backside of the first major surface from the support substrate 21 side to mount a plurality of electronic parts on the first major surface side. The heat conductive layer 41 arranged on the first major surface side includes a plurality of parts which is configured to be independently electrically coupled to the electronic parts. The heat conductive layer 42 arranged on the second major surface side has a projection area of a perspective plane view that is larger than a projection area of a perspective plane view which the heat conductive layer 41 arranged on the first major surface side has.

<Eighth Embodiment>

The heat radiation base body 1 shown in FIG. 9 is the heat radiation base body 1 in which the first metal layers 31 and 32, the heat conductive layers 41 and 42, the intermediate layers 61 and 62, and the second metal layers 51 and 52 are sequentially laminated on the first major surface and the second major surface of the support substrate 21 from the support substrate 21 side to mount a plurality of electronic parts on the first major surface side. The heat conductive layer 41 arranged on the first major surface side includes a plurality of parts to be independently electrically coupled to the electronic parts. The heat conductive layer 42 arranged on the second major surface side has a planarly-viewed projection area that is larger than a projection area of the heat conductive layer 41 arranged on the first major surface side.

In each of the heat radiation base bodys 1 according to the seventy embodiment and the eighth embodiment, since the planarly-viewed projection area of the heat conductive layer 42 arranged on the second major surface side is larger than the projection area of the heat conductive layer 41 arranged on the first major surface side, heat generated from the electronic parts mounted on the first major surface side efficiently diffused and discharged. For this reason, a heat discharge characteristic can be improved.

<Ninth Embodiment>

The heat radiation base body 1 shown in FIG. 10 is the heat radiation base body 1 in which the first metal layers 31 and 32, the heat conductive layers 41 and 42, and the second metal layers 51 and 52 are sequentially laminated on the first major surface and the second major surface of the support substrate 21 from the support substrate 21 side to mount a plurality of electronic parts on the first major surface side. The heat conductive layer 41 arranged on the first major surface side includes a plurality of parts to be independently electrically coupled to the electronic parts. The heat conductive layer 42 arranged on the second major surface side is configured by a single layer.

<Tenth Embodiment>

In the heat radiation base body 1 shown in FIG. 11, the intermediate layers 61 and 62 containing, as a main component, at least one metal element selected from chromium, manganese, iron, cobalt, and nickel are formed between the heat conductive layer 41 and the second metal layer 51 and between the heat conductive layer 42 and the second metal layer 52 of the heat radiation base body 1 shown in FIG. 10. Although not shown, an intermediate layer containing, as a main component, at least one metal element selected from chromium, manganese, iron, cobalt, and nickel may be formed between the heat conductive layer 41 and the first metal layer 31 of the heat radiation base body 1 shown in FIG. 11. Intermediate layers are more preferably formed between the heat conductive layer 41 and the first metal layer 31, between the heat conductive layer 41 and the second metal layer 51, and between the heat conductive layer 42 and the first metal layer 32 and between the heat conductive layer 42 and the second metal layer 52.

As in the heat radiation base body 1 according to the tenth embodiment, the intermediate layers 61 and 62 containing at least one metal element selected from chromium, manganese, iron, cobalt, and nickel as a main component are preferably formed between the heat conductive layer 41 and the second metal layer 51 and between the heat conductive layer 42 and the second metal layer 52. In this manner, since the second metal layers 51 and 52 are not easily peeled by heat generated during an operation of the electronic part, the reliability can be more improved.

<Eleventh Embodiment>

In the heat radiation base body 1 shown in FIG. 12, the covering layers 71 and 72 composed of a silver-copper alloy containing at least one metal element selected from titanium, zirconium, hafnium, and niobium are formed on the side surfaces of the heat conductive layers 41 and 42 shown in FIG. 10.

In the heat radiation base body 1 shown in FIG. 13, the covering layers 71 and 72 composed of a silver-copper alloy containing at least one metal element selected from titanium, zirconium, hafnium, and niobium are formed on the side surfaces of the heat conductive layers 41 and 42 of the heat radiation base body 1 shown in FIG. 11.

In the heat radiation base body 1 according to the eleventh embodiment, since the covering layers 71 and 72 composed of a silver-copper alloy containing at least one metal element selected from titanium, zirconium, hafnium, and niobium are formed on the side surfaces of the heat conductive layers 41 and 42, moisture in the air is not easily absorbed by the heat conductive layers 41 and 42.

<Twelfth Embodiment>

In the heat radiation base body 1 shown in FIG. 14, the covering layers 71 and 72 composed of at least one metal element selected from gold, copper, aluminum, tin, and zinc are formed on the side surfaces of the heat conductive layers 41 and 42 and the second metal layers 51 and 52 shown of the heat radiation base body 1 in FIG. 11. The metal elements may be mutually diffused to form an alloy.

In the heat radiation base body 1 according to the twelfth embodiment, the covering layers 71 and 72 containing at least one metal element selected from gold, copper, aluminum, tin, and zinc are formed on the side surfaces of the heat conductive layers 41 and 42 and the second metal layers 51 and 52, moisture in the air does not easily enter from the second metal layers 51 and 52 side. For this reason, the moisture is more hard to be absorbed in the heat conductive layers 41 and 42. In each of the heat radiation base bodys 1 according to the eleventh embodiment and the twelfth embodiment, even though the moisture in the air is absorbed in the heat conductive layers 41 and 42, the vapor is suppressed by the covering layers 71 and 72. For this reason, the first metal layers 31 and 32 and the second metal layers 51 and 52 are not easily corroded, and the reliability can be improved.

The thickness of each of the covering layers 71 and 72 is preferably 20 $\mu$m or more to 200 $\mu$m or less.

In each of the heat radiation base bodys 1 according to the ninth embodiment to the twelfth embodiment, since the heat conductive layer 42 arranged on the second major surface side is configured by a single layer, the area of the heat conductive layer 42 can be made larger than that of the heat conductive layer 41 arranged on the first major surface side. In this manner, since heat generated from the electronic part mounted on the first major surface side is efficiently diffused and discharged, the heat discharge characteristic of the heat radiation base body 1 can be improved.

<Thirteenth Embodiment>

The heat radiation base body 1 shown in FIG. 15 has the same basic configuration as that of the heat radiation base body 1 shown in FIG. 11. However, at least a part on the side surface of the heat conductive layer 41 arranged on the first major surface and the side surface of the heat conductive layer 42 arranged on the second major surface side is inclined outward toward the support substrate 21. Since the part is inclined outward toward the support substrate 21, junction areas between the support substrate 21 and the heat conductive layers 41 and 42 can be increased, and a heat exchange from the first major surface side to the second major surface side more rapidly progresses. For this reason, the reliability can be improved.

<Fourteenth Embodiment>

The heat radiation base body 1 shown in FIG. 16 has the same basic configuration as that of the heat radiation base body 1 shown in FIG. 11. However, at least a part on the side surface of the heat conductive layer 41 arranged on the first major surface and the side surface of the heart conductive layer 42 arranged on the second major surface side has a step spreading outward on the side of the support substrate 21. Since the part has the step spreading outward on the side of the support substrate 21, the junction areas between the support substrate 21 and the heat conductive layers 41 and 42 can be increased, and a heat exchange from the first major surface side to the second major surface side more rapidly progresses. For this reason, the reliability is improved.

In the first embodiment to the thirteenth embodiment, the support substrate 21 is composed of, for example, a ceramics containing, as a main component, a silicon nitride, an aluminum nitride, an aluminum oxide, a beryllium oxide, or a zirconium oxide as described above. In particular, when the support substrate 21 is composed of the ceramic containing, as a main component, a silicon nitride, an aluminum nitride, or an aluminum oxide, all the components have high heat conductivities and excellent mechanical characteristics. For this reason, the heat discharge characteristics and the reliability can be improved.

<Electronic Device>

In an electronic device according to the embodiment, since the electronic parts are mounted on the second metal layer 51 on the heat radiation base body 1 having an improved heat discharge characteristic in the first embodiment to the fourteenth embodiment described above. The electronic device having an improved heat discharge characteristic can be obtained.

The heat radiation base body 1 according to the embodiment can use heat generated by various electronic parts such as an insulating gate bipolar transistor (IGBT) element, a metal oxide film field effect transistor (MOSFET) element, a light emitting diode (LED) element, a free wheeling diode (FWD) element, giant transistor (GTR) element, a semiconductor element such as a peltier element, a sublimination type thermal printer head element, and a thermal ink-jet printer head element while rarely deteriorating heat radiation efficiency for a long period of time because the heat radiation base body 1 has the improved heat discharge characteristic as described above.

<Method of Manufacturing Heat Radiation Base body>

An example of the method of manufacturing a heat radiation base body according to the present invention will be described below.

For the heat radiation base body 1 according to the present invention, the support substrate 21 composed of a ceramics having a length in an X direction of 20 mm or more to 200 mm or less, a length in a Y direction of 10 mm or more to 200 mm or less, and a thickness of 0.2 mm or more to 1.0 mm or less and containing a silicon nitride, an aluminum nitride, an aluminum oxide, a beryllium oxide, or a zirconium oxide as a main component is formed. On both the major surfaces of the support substrate 21, a paste-like brazing filler metal containing at least one metal element selected from titanium, zirconium, hafnium, and niobium and at least one metal element selected from indium and tin as needed and containing silver or copper as a main component is applied by using one method selected from a screen printing method, a roll coater, a brush application, and the like to cause the thicknesses of the first metal layers 31 and 32 to have thicknesses of 10 $\mu$m or more to 30 $\mu$m or less. The support substrate 21 may be cut in the later step to have a size at which the plurality of support substrates 1 can be manufactured.

The heat conductive layers 41 and 42 made of carbon sintered bodies each having a length in an X direction of 5 mm or more to 120 mm or less, a length in a Y direction of 5 mm or more to 100 mm or less, a thickness of 0.5 mm or more to 10.0 mm or less, and a relative density of, for example, 80% or more are arranged on both the sides of the support substrate 21 through the paste-like brazing filler metal. The resultant structure is heated at a temperature falling within the range of 800 to 900°C in a vacuum atmosphere having an ultimate vacuum of $10^{-2}$ Pa or less while being pressured and then cooled to bond the support substrate 21 and the heat conductive layers 41 and 42 to each other. The first metal layers 31 and 32 are formed between the support substrate 21 and the heat conductive layers 41 and 42.

In this case, when intermediate layers (not shown) are formed between the heat conductive layer 41 and the first metal layer 31 and between the heat conductive layer 42 and the first metal layer 32, on the major surfaces of the first metal layers 31 and 32, the intermediate layers 61 and 62 containing, as main components, at least one metal element selected from chromium, manganese, iron, cobalt, and nickel may be formed by a method selected from an electroless plating method, an electrolytic plating method, a sputtering method, a chemical vapor deposition method (CVD method (Chemical Vapor Deposition method)), a chemical vapor reaction method (CVR method (Chemical Vapor Reaction method)) and the like.

In order to obtain the heat radiation base body 1 in which at least a part on the side surfaces of the heat conductive layers 41 and 42 is inclined outward toward the support substrate 21 or having a step spreading outward on the side of the support substrate 21, the heat conductive layers 41 and 42 having such shapes formed in advance may be used. The heat conductive layers 41 and 42 and the first metal layers 31 and 32 are patterned by using a method selected from milling, dicing, blasting, honing, etching, laser machining, ultrasonic machining, electric discharge machining, and the like to have predetermined shapes.

In this case, when the covering layers 71 and 72 composed of a silver-copper alloy containing at least one metal element selected from titanium, zirconium, hafnium, and niobium are formed on the side surface of the heat conductive layers 41 and 42, one selected from a paste-like brazing filler metal containing at least one metal element selected from titanium, zirconium, hafnium, and niobium and containing silver and copper as main components, a paste-like brazing filler metal containing tin as a main component, an aluminum-silicon base paste-like brazing filler metal, an aluminum alloy paste-like brazing filler metal, a silver paste-like brazing filler metal, and the like is applied to the side surfaces of the patterned heat conductive layers 41 and 42 and heated. Thereafter, the resultant structures may be patterned by using one selected from milling, dicing, blasting, honing, etching, laser machining, ultrasonic machining, electric discharge machining, and the like to set the thicknesses of the covering layers 71 and 72 to 20 $\mu$m or more to 200 $\mu$m or less. The heating temperature may be set to a temperature lower than the temperature at which the first metal layers 31 and 32 are formed.

When the intermediate layers 61 and 62 are formed between the heat conductive layer 41 and the second metal layer 51 and between the heat conductive layer 42 and the second metal layer 52, on the major surfaces of the heat conductive layers 41 and 42, the intermediate layers 61 and 62 containing, as main components, at least one metal element selected from chromium, manganese, iron, cobalt, and nickel may be formed by a method selected from an electroless plating method, an electrolytic plating method, a sputtering method, a chemical vapor deposition method (CVD method), a chemical vapor reaction method (CVR method) and the like.

When the intermediate layers 61 and 62 are formed on the heat conductive layers 41 and 42, the second metal layers 51 and 52 containing silver, copper, aluminum, tungsten, or molybdenum as main components are formed on the intermediate layers 61 and 62 by a method selected from an electroless plating method, a sputtering method, an electroforming method, a spraying method, and the like.

In this case, when the covering layers 71 and 72 composed of at least one metal element selected from gold, copper, aluminum, tin, and zinc are formed on the side surfaces of the heat conductive layers 41 and 42 and the second metal layers 51 and 52, the covering layers 71 and 72 are formed by using an electroless plating method or an electrolytic plating method.

As needed, the support substrate 21 may be cut by using a method selected from laser machining, dicing, ultrasonic machining, and the like to have predetermined sizes.

Finally, after an excessive metal element fixed to or adhering to the support substrate 21 is removed by blasting and honing as needed, the support substrate 21 is cleansed by using ultrasonic waves to make it possible to obtain the heat radiation base body 1 according to the present invention.

In the heat radiation base body 1 obtained as described above, since the difference between the linear expansion coefficients of the support substrate 21 and the heat conductive layers 41 and 42 can be reduced, thermal stress generated in the bonding step decreases. For this reason, warp occurring in the support substrate 21 decreases. Since the heat radiation base body 1 in which the heat conductive layers 41 and 42 are arranged on both the major surfaces of the support substrate 21 and increased in thickness has an improved heat discharge characteristic, depending on cases, a heat sink to cool an electronic part need not be attached.

Example

Examples of the present invention will be concretely described below. The present invention is not limited to the examples.

[Example 1]

Example 1 of the present invention will be described by using the heat radiation base body 1 shown in FIGS. 12 and 13.

Firstly, in order to obtain a plurality of heat radiation base bodys 1 shown in FIGS. 12 and 13, on both the major surfaces of the support substrate 21 containing a silicon nitride as a main component and having a thickness of 0.32 mm, a paste-like brazing filler metals containing main components shown in Tables 1 to 4 were applied by screen printing to form the first metal layers 31 and 32 containing additives shown in Tables 1 to 4.

Next, the heat conductive layers 41 and 42 composed of carbonaceous sintered bodies each having a relative density of 30 a and having thicknesses $t_4$ shown in Tables 1 to 4 were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 $\mu$m and to bond the support substrate 21 and the heat conductive layers 41 and 42 to each other.

The heat conductive layers 41 and 42 and the first metal layers 31 and 32 were patterned by electric discharge machining to have shapes shown in FIGS. 12 and 13.

On the side surfaces of the patterned heat conductive layers 41 and 42 and the patterned first metal layers 31 and 32, a paste-like brazing filler metal containing aluminum and silicon, the contents of which are 88% by weight and 12% by weight, respectively, were applied and heated at 600°C.

With respect to Samples No. 4 to 18, 23, 28 to 42, 47, 52 to 66, 71, 76 to 90, and 95, the intermediate layers 61 and 62 containing components shown in Tables 1 to 4 and the contents of which were 99% by weight were formed to have thicknesses $t_6$ shown in Tables 1 to 4.

In this case, with respect to Samples No. 1 to 3, 19 to 22, 24 to 27, 43 to 46, 48 to 51, 67 to 70, 72 to 75, 90 to 93, and 95, the second metal layers 51 and 52 containing the components shown in Tables 1 to 4 as main components were formed on the heat conductive layers 41 and 42 by a thermal spray method, With respect to Samples No. 4 to 18, 23, 28 to 42, 47, 52 to 66, 71, 76 to 90, and 95, the second metal layers 51 and 52 containing the components shown in Tables 1 to 4 as main components were formed on the intermediate layers 61 and 62 by a thermal spray method. The side surfaces of the heat conductive layers 41 and 42 were patterned by using electric discharge machining to form the covering layers 71 and 72. Thereafter, the support substrate 21 was cut by laser machining to laminate first metal layers 31 and 32, the heat conductive layers 41 and 42, and the second metal layers 51 and 52 on both the major surfaces of the support substrate 21, the major surfaces of which have an area of 2.7 x $10^3$ mm$^2$, and Samples No. 1 to 95 serving as the heat radiation base bodys 1 shown in FIGS. 12 and 13 were obtained. A total area of each major surface of the heat conductive layer 41 and an area of one major surface of the heat conductive layer 42 are as shown in Tables 1 to 4.

As a comparative example, a paste-like brazing filler metal composed of a silver-copper alloy containing titanium was applied by screen printing method on both the major surfaces of the ceramic substrate 81 containing a silicon nitride as a main component and a thickness of 0.32 mm.

Next, in the state that the copper plates 82 of 2 rows and 3 columns and the single copper plate 83 were arranged in contact with both the major surfaces of the ceramic substrate 81, the ceramic substrate 81 and the copper plates 82 and 83 are bonded to each other by heating to 1070°C in a vacuum atmosphere having an ultimate vacuum of $10^{-2}$ Pa or less. The ceramic substrate 81 was cut by laser machining, and the copper plates 82 and 83 were bonded to the ceramic substrate 81 each major surface of which has an area of 2.7 x $10^3$ mm$^2$ to form Samples Nos. 97 and 98 serving as parts of the heat radiation base body 80 shown in FIG. 17.

A total area of each major surface of the copper plate 82 and an area of one major surface of the copper plate 83 are as shown in Tables 4. As both the copper plates, copper plates made of tough pitch electrolytic copper containing 0.1% by weight of oxygen were used.

By using a contact probe profilometer in conformity to JIS B 0601-2001 (ISO 4287-1997), maximum heights $R_z$ in the longitudinal directions of the support substrate 21 and the ceramic substrate 81 were measured, and the measurement values were estimated as warps. The measurement values are shown in Tables 1 to 4. A measurement length, a cutoff value, a distal end radius of a probe, and a scanning rate of the probe are given by 55 mm, R + W, 2 $\mu$m, and 1 mm/sec, respectively, and values of the measured warps are shown in Tables to 4. A sample in which a sign - (minus) is added before the value of the warp shows that a concave warp occurs toward the second major surface side, and a sample in which a sign is not added before the value of the warp shows that a convex warp occurs toward the second major surface side.

A simulation was performed on the supposition that an amount of heat of 40 W/m$^2$ per unit area was given to the major surfaces of the second metal layer 51 and the copper plate 82 to estimate heat resistances of the samples. The estimate values are shown in Tables 1 to 4.

A heat cycle test for each of the samples was performed to confirm the presence/absence of cracks occurring in the support substrate 21 and the ceramic substrate 81 by a twentyfold optical microscope using a fluorescent penetrant inspection method each time 100 cycles passed after 3000 cycles. A cycle in which a temperature was decreased from the room temperature to -45°C, kept at the temperature for 15 minutes, increased to 125°C, kept at the temperature for 15 minutes, and decreased to the room temperature was defined as one cycle. A cycle number at which cracks are confirmed for the first time in the support substrate 21 and the ceramic substrate 81 are shown in Tables 1 to 4.

Independently of the heat cycle test, peel strength of the second metal layer 51 was measured in conformity to JIS C 6481-1996 to evaluate a bond strength between the heat conductive layer 41 and the second metal layer 51. The covering layer 71 was removed by etching before the peel strength was measured to make the widths of the heat conductive layer 41 and the second metal layer 51 10 mm.

[Table 1]

| Sample No. | Additive to First Metal Layers 31, 32 | Main Component of First Metal Layers 31,32 | Each Thickness $t_4$ of Heat Conducive Layers 41, 42 (mm) | Each Thickness $t_5$ of Second Metal Layers 51, 52 (mm) | Ratio $(t_5/t_4)$ (%) | Main Component of Intermediate Layers 61, 62 | Main Component of Second Metal Layers 51, 52 | Each Thickness $t_6$ of Intermediate layers 61, 62 ($\mu$m) | Total Area of Each Mayor Surface of Heat Conductive Layer 41 ($\times 10^3 mm^2$) | Area of Heat Conductive Layer 42 ($\times 10^3 mm^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 1 | Ti | Ag | 2 | 0. 4 | 20 | - | Cu | - | 2. 4 | 2. 5 | -106 | 5. 2 | 0. 16 | 3000 |
| 2 | Ti | Ag | 2 | 0. 3 | 15 | - | Cu | - | 2. 4 | 2. 5 | -85 | 5. 9 | 0. 18 | 3300 |
| 3 | Ti | Ag | 2 | 0. 2 | 10 | - | Cu | - | 2. 4 | 2. 5 | -42 | 6. 6 | 0. 21 | 3600 |
| 4 | Ti | Ag | 2 | 0. 4 | 20 | Ni | Cu | 15 | 2. 4 | 2. 5 | -107 | 7. 5 | 0. 17 | 3600 |
| 5 | Ti | Ag | 2 | 0. 3 | 15 | Ni | Cu | 15 | 2. 4 | 2. 5 | -84 | 8. 2 | 0. 19 | 4000 |
| 6 | Ti | Cu | 2 | 0. 3 | 15 | Ni | Ag | 15 | 2. 4 | 2. 5 | -75 | 9. 3 | 0. 18 | 4000 |
| 7 | Ti | Cu | 2 | 0. 3 | 15 | Ni | Fe | 15 | 2. 4 | 2. 5 | -70 | 8. 2 | 0. 3 | 4300 |
| 8 | Ti | Cu | 2 | 0. 3 | 15 | Ni | W | 15 | 2. 4 | 2. 5 | -35 | 8. 4 | 0. 24 | 4500 |
| 9 | Ti | Cu | 2 | 0. 3 | 15 | Ni | Mo | 15 | 2. 4 | 2. 5 | -41 | 8. 4 | 0. 25 | 4500 |
| 10 | Ti | Cu | 2 | 0. 3 | 15 | Ni | Ni | 15 | 2. 4 | 2. 5 | -76 | 8. 5 | 0. 28 | 4000 |
| 11 | Ti | Cu | 2 | 0. 3 | 15 | Ni | Cu | 15 | 2. 4 | 2. 5 | -107 | 8. 2 | 0. 18 | 4000 |
| 12 | Ti | Sn | 2 | 0. 3 | 15 | Ni | Cu | 15 | 2. 4 | 2. 5 | -104 | 8. 1 | 0. 2 | 3000 |
| 13 | Ti | Ag | 2 | 0. 3 | 15 | Cr | Cu | 15 | 2. 4 | 2. 5 | -100 | 8. 2 | 0. 18 | 4000 |
| 14 | Ti | Ag | 2 | 0. 3 | 15 | Ni. Cr | Cu | 15 | 2. 4 | 2. 5 | -100 | 8. 2 | 0. 19 | 4000 |
| 15 | Ti | Ag | 2 | 0. 3 | 15 | Mn | Cu | 15 | 2. 4 | 2. 5 | -102 | 8. 1 | 0. 18 | 4000 |
| 16 | Ti | Ag | 2 | 0. 3 | 15 | Fe | Cu | 15 | 2. 4 | 2. 5 | -104 | 7. 9 | 0. 18 | 4000 |
| 17 | Ti | Ag | 2 | 0. 3 | 15 | Co | Cu | 15 | 2. 4 | 2. 5 | -99 | 8. 2 | 0. 18 | 4000 |

| Sample No. | Additive to First Metal Layers 31, 32 | Main Component of First Metal Layers 31,32 | Each Thickness $t_4$ of Heat Conducive Layers 41, 42 (mm) | Each Thickness $t_5$ of Second Metal Layers 51, 52 (mm) | Ratio $(t_5/t_4)$ (%) | Main Component of Intermediate Layers 61, 62 | Main Component of Second Metal Layers 51, 52 | Each Thickness $t_6$ of Intermediate layers 61, 62 ($\mu$m) | Total Area of Each Mayor Surface of Heat Conductive Layer 41 ($\times 10^3$mm$^2$) | Area of Heat Conductive Layer 42 ($\times 10^3$mm$^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 18 | Ti | Ag | 2 | 0. 2 | 10 | Ni | Cu | 15 | 2. 4 | 2. 5 | -44 | 8. 5 | 0. 21 | 4500 |
| 19 | Ti | Ag | 1 | 0. 4 | 40 | - | Cu | - | 2. 4 | 2. 5 | -118 | 5. 2 | 0. 22 | 3000 |
| 20 | Ti | Ag | 1 | 0. 3 | 30 | - | Cu | - | 2. 4 | 2. 5 | -98 | 5. 9 | 0. 24 | 3000 |
| 21 | Ti | Ag | 1 | 0. 2 | 20 | - | Cu | - | 2. 4 | 2. 5 | -51 | 6. 6 | 0. 26 | 3500 |
| 22 | Ti | Ag | 2 | 0. 3 | 15 | - | Cu | - | 2. 4 | 2. 5 | -123 | 6 | 0. 16 | 3200 |
| 23 | Ti | Ag | 2 | 0 3 | 15 | Ni | Cu | 15 | 2. 4 | 2. 5 | -125 | 8. 3 | 0. 16 | 3500 |
| 24 | Ti | Ag | 1 | 0. 3 | 30 | - | Cu | - | 2. 4 | 2. 5 | -126 | 6. 1 | 0. 2 | 3000 |

[Table 2]

| Sample No. | Additive to First Metal Layers 31,32 | Main Component of First Metal Layers 31, 32 | Each Thickness $t_4$ of Heat Conductive Layers 41, 42 (mm) | Each Thickness $t_5$ of Second Metal Layers 51, 52 (mm) | Ratio $(t_5/t_4)$ (%) | Main Component of Intermediate Layers 61, 62 | Main Component of Second Metal Layers 51, 52 | Each Thickness $t_6$ of Intermediate layers 61, 62 ($\mu$m) | Total Area of Each Major Surface of Heat Conductive Layer 41 ($\times 10^3 mm^2$) | Area of Heat Conducive Layer 42 ($\times 10^3 mm^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 25 | Zr | Ag | 2 | 0.4 | 20 | - | Cu | - | 2.4 | 2.5 | -103 | 5.2 | 0.16 | 3000 |
| 26 | Zr | Ag | 2 | 0.3 | 15 | - | Cu | - | 2.4 | 2.5 | -81 | 5.9 | 0.18 | 3300 |
| 27 | Zr | Ag | 2 | 0.2 | 10 | - | Cu | - | 2.4 | 2.5 | -38 | 6.6 | 0.21 | 3600 |
| 28 | Zr | Ag | 2 | 0.4 | 20 | Ni | Cu | 15 | 2.4 | 2.5 | -100 | 7.5 | 0.17 | 3600 |
| 29 | Zr | Ag | 2 | 0.3 | 15 | Ni | Cu | 15 | 2.4 | 2.5 | -80 | 8.2 | 0.19 | 4000 |
| 30 | Zr | Ag | 2 | 0.3 | 15 | Ni | Al | 15 | 2.4 | 2.5 | -71 | 9.3 | 0.22 | 4000 |
| 31 | Zr | Ag | 2 | 0.3 | 15 | Ni | Fe | 15 | 2.4 | 2.5 | -67 | 8.2 | 0.3 | 4300 |
| 32 | Zr | Ag | 2 | 0.3 | 15 | Ni | W | 15 | 2.4 | 2.5 | -31 | 8.4 | 0.24 | 4500 |
| 33 | Zr | Ag | 2 | 0.3 | 15 | Ni | Mo | 15 | 2.4 | 2.5 | -57 | 8.4 | 0.25 | 4500 |
| 34 | Zr | Ag | 2 | 0.3 | 15 | Ni | Ni | 15 | 2.4 | 2.5 | -72 | 8.5 | 0.28 | 4000 |
| 35 | Zr | Cu | 2 | 0.3 | 15 | Ni | Cu | 15 | 2.4 | 2.5 | -103 | 8.2 | 0.18 | 4000 |
| 36 | Zr | Sn | 2 | 0.3 | 15 | Ni | Cu | 15 | 2.4 | 2.5 | -99 | 8.1 | 0.2 | 3000 |
| 37 | Zr | Ag | 2 | 0.3 | 15 | Ni.Cr | Cu | 15 | 2.4 | 2.5 | -96 | 8.2 | 0.18 | 4000 |
| 38 | Zr | Ag | 2 | 0.3 | 15 | Cr | Cu | 15 | 2.4 | 2.5 | -95 | 8.2 | 0.18 | 4000 |
| 39 | Zr | Ag | 2 | 0.3 | 15 | Mn | Cu | 15 | 2.4 | 2.5 | -97 | 8.1 | 0.18 | 4000 |
| 40 | Zr | Ag | 2 | 0.3 | 15 | Fe | Cu | 15 | 2.4 | 2.5 | -97 | 7.9 | 0.18 | 4000 |

| Sample No. | Additive to First Metal Layers 31,32 | Main Component of First Metal Layers 31, 32 | Each Thickness $t_4$ of Heat Conductive Layers 41, 42 (mm) | Each Thickness $t_5$ of Second Metal Layers 51, 52 (mm) | Ratio ($t_5/t_4$) (%) | Main Component of Intermediate Layers 61, 62 | Main Component of Second Metal Layers 51, 52 | Each Thickness $t_6$ of Intermediate layers 61, 62 ($\mu$m) | Total Area of Each Major Surface of Heat Conductive Layer 41 ($\times 10^3 mm^2$) | Area of Heat Conducive Layer 42 ($\times 10^3 mm^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 41 | Zr | Ag | 2 | 0.3 | 15 | Co | Cu | 15 | 2.4 | 2.5 | -95 | 8.2 | 0.18 | 4000 |
| 42 | Zr | Ag | 2 | 0.2 | 10 | Ni | Cu | 15 | 2.4 | 2.5 | -38 | 8.5 | 0.21 | 4500 |
| 43 | Zr | Ag | 1 | 0.4 | 40 | - | Cu | - | 2.4 | 2.5 | -112 | 5.2 | 0.22 | 3000 |
| 44 | Zr | Ag | 1 | 0.3 | 30 | - | Cu | - | 2.4 | 2.5 | -93 | 5.9 | 0.24 | 3000 |
| 45 | Zr | Ag | 1 | 0.2 | 20 | - | Cu | - | 2.4 | 2.5 | -57 | 6.6 | 0.26 | 3500 |
| 46 | Zr | Ag | 2 | 0.3 |  | - | Cu | - | 2.4 | 2.5 | -118 | 6 | 0.16 | 3200 |
| 47 | Zr | Ag | 2 | 0.3 | 15 | Ni | Cu | 15 | 2.4 | 2.5 | -118 | 8.3 | 0.16 | 3500 |
| 48 | Zr | Ag | 1 | 0.3 | 30 | - | Cu | - | 2.4 | 2.5 | -121 | 6.1 | 0.2 | 3000 |

EP 2 393 110 A1

[Table 3]

| Sample No. | Additive to First Metal Layers 31.32 | Main Component of First Metal Layers 31, 32 | Each Thickness $t_4$ of Heat Conductive Layers 41, 42 (mm) | Each Thickness $t_6$ of Second Metal Layers 51, 52 (mm) | Ratio ($t_5/t_4$) (%) | Main Component of Intermediate Layers 61, 62 | Main Component of Second Metal Layers 51,52 | Each Thickness $t_6$ of Intermediate layers 61, 62 ($\mu$m) | Total Area of Each Major Surface of Heat Conductive Layer 41 ($\times 10^3$mm$^2$) | Area of Heat Conductive Layer 42 ($\times 10^3$mm$^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 49 | Hf | Ag | 2 | 0.4 | 20 | - | Cu | - | 2.4 | 2.5 | -112 | 5.2 | 0.16 | 3000 |
| 50 | Hf | Ag | 2 | 0.3 | 15 | - | Cu | - | 2.4 | 2.5 | -91 | 5.9 | 0.18 | 3300 |
| 51 | Hf | Ag | 2 | 0.2 | 10 | - | Cu | - | 2.4 | 2.5 | -46 | 6.6 | 0.21 | 3600 |
| 52 | Hf | Ag | 2 | 0.4 | 20 | Ni | Cu | 15 | 2.4 | 2.5 | -113 | 7.5 | 0.17 | 3600 |
| 53 | Hf | Ag | 2 | 0.3 | 15 | Ni | Cu | 15 | 2.4 | 2.5 | -89 | 8.2 | 0.19 | 4000 |
| 54 | Hf | Ag | 2 | 0.3 | 15 | Ni | Al | 15 | 2.4 | 2.5 | -80 | 9.3 | 0.22 | 4000 |
| 55 | Hf | Ag | 2 | 0.3 | 15 | Ni | Fe | 15 | 2.4 | 2.5 | -76 | 8.2 | 0.3 | 4300 |
| 56 | Hf | Ag | 2 | 0.3 | 15 | Ni | W | 15 | 2.4 | 2.5 | -42 | 8.4 | 0.24 | 4500 |
| 57 | Hf | Ag | 2 | 0.3 | 15 | Ni | Mo | 15 | 2.4 | 2.5 | -47 | 8.4 | 0.25 | 4500 |
| 58 | Hf | Cu | 2 | 0.3 | 15 | Ni | Ni | 15 | 2.4 | 2.5 | -82 | 8.5 | 0.28 | 4000 |
| 59 | Hf | Cu | 2 | 0.3 | 15 | Ni | Cu | 15 | 2.4 | 2.5 | -112 | 8.2 | 0.18 | 4000 |
| 60 | Hf | Sn | 2 | 0.3 | 15 | Ni | Cu | 15 | 2.4 | 2.5 | -109 | 8.1 | 0.2 | 3000 |
| 61 | Hf | Ag | 2 | 0.3 | 15 | Ni.Cr | Cu | 15 | 2.4 | 2.5 | -108 | 8.2 | 0.18 | 4000 |
| 62 | Hf | Ag | 2 | 0.3 | 15 | Cr | Cu | 15 | 2.4 | 2.5 | -106 | 8.2 | 0.18 | 4000 |
| 63 | Hf | Ag | 2 | 0.3 | 15 | Mn | Cu | 15 | 2.4 | 2.5 | -106 | 8.1 | 0.18 | 4000 |
| 64 | Hf | Ag | 2 | 0.3 | 15 | Fe | Cu | 15 | 2.4 | 2.5 | -110 | 7.9 | 0.18 | 4000 |
| 65 | Hf | Ag | 2 | 0.3 | 15 | Co | Cu | 15 | 2.4 | 2.5 | -103 | 8.2 | 0.18 | 4000 |

| Sample No. | Additive to First Metal Layers 31,32 | Main Component of First Metal Layers 31, 32 | Each Thickness $t_4$ of Heat Conductive Layers 41, 42 (mm) | Each Thickness $t_6$ of Second Metal Layers 51, 52 (mm) | Ratio $(t_5/t_4)$ (%) | Main Component of Intermediate Layers 61, 62 | Main Component of Second Metal Layers 51,52 | Each Thickness $t_6$ of Intermediate layers 61, 62 ($\mu$m) | Total Area of Each Major Surface of Heat Conductive Layer 41 ($\times 10^3$mm$^2$) | Area of Heat Conductive Layer 42 ($\times 10^3$mm$^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 66 | Hf | Ag | 2 | 0.2 | 10 | Ni | Cu | 15 | 2.4 | 2.5 | -49 | 8.5 | 0.21 | 4500 |
| 67 | Hf | Ag | 1 | 0.4 | 40 | - | Cu | - | 2.4 | 2.5 | -125 | 5.2 | 0.22 | 3000 |
| 68 | Hf | Ag | 1 | 0.3 | 30 | - | Cu | - | 2.4 | 2.5 | -103 | 5.9 | 0.24 | 3000 |
| 69 | Hf | Ag | 1 | 0.2 | 20 | - | Cu | - | 2.4 | 2.5 | -53 | 6.6 | 0.26 | 3500 |
| 70 | Hf | Ag | 2 | 0.3 | 15 | - | Cu | - | 2.4 | 2.5 | -126 | 6 | 0.16 | 3200 |
| 71 | Hf | Ag | 2 | 0.3 | 15 | Ni | Cu | 15 | 2.4 | 2.5 | -128 | 8.3 | 0.16 | 3500 |
| 72 | Hf | Ag | 1 | 0.3 | 30 | - | Cu | - | 2.4 | 2.5 | -131 | 6.1 | 0.2 | 3000 |
| 73 | Nb | Ag | 2 | 0.4 | 20 | - | Cu | - | 2.4 | 2.5 | -111 | 5.2 | 0.16 | 3000 |
| 74 | Nb | Ag | 2 | 0.3 | 15 | - | Cu | - | 2.4 | 2.5 | -89 | 5.9 | 0.18 | 3300 |

[Table 4]

| Sample No. | First to First Metal Layers 31,32 | Main Component of First Metal Layers 31, 32 | Each Thickness $t_4$ of Heat Conductive Layers 41, 42 (mm) | Each Thickness $t_5$ of Second Mental Layers 51.52 (mm) | Ratio $(t_5/t_4)$ (%) | Main Component of Intermediate Layers 61. 62 | Main Component of Second Metal Layers 51, 52 | Each Thickness $t_6$ of Intermediate layers 61. 62 ($\mu$m) | Total Area of Each Major Surface of Heat Conductive Layer 41 ($\times 10^3$mm$^2$) | Area of Heat Conductive Layers 42 ($\times 10^3$mm$^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 75 | Nb | Ag | 2 | 0.2 | 10 | - | Cu | - | 2.4 | 2.5 | -44 | 6.6 | 0.21 | 3600 |
| 76 | Nb | Ag | 2 | 0.4 | 20 | Ni | Cu | 15 | 2.4 | 2.5 | -111 | 7.5 | 0.17 | 3600 |
| 77 | Nb | Ag | 2 | 0.3 | 15 | Ni | Cu | 15 | 2.4 | 2.5 | -87 | 8.2 | 0.19 | 4000 |
| 78 | Nb | Cu | 2 | 0.3 | 15 | Ni | Ag | 15 | 2.4 | 2.5 | -78 | 9.3 | 0.18 | 4000 |
| 79 | Nb | Cu | 2 | 0.3 | 15 | Ni | Fe | 15 | 2.4 | 2.5 | -72 | 8.2 | 0.3 | 4300 |
| 80 | Nb | Cu | 2 | 0.3 | 15 | Ni | w | 15 | 2.4 | 2.5 | -39 | 8.4 | 0.24 | 4500 |
| 81 | Nb | Cu | 2 | 0.3 | 15 | Ni | Mo | 15 | 2.4 | 2.5 | -44 | 8.4 | 0.25 | 4500 |
| 82 | Nb | Cu | 2 | 0.3 | 15 | Ni | Ni | 15 | 2.4 | 2.5 | -79 | 8.5 | 0.28 | 4000 |
| 83 | Nb | Cu | 2 | 0.3 | 15 | Ni | Cu | 15 | 2.4 | 2.5 | -111 | 8.2 | 0.18 | 4000 |
| 84 | Nb | Sn | 2 | 0.3 | 15 | Ni | C$\mu$ | 15 | 2.4 | 2.5 | -107 | 8.1 | 0.2 | 3000 |
| 85 | Nb | Ag | 2 | 0.3 | 15 | Nt. Cr | Cu | 15 | 2.4 | 2.5 | -103 | 8.2 | 0.18 | 4000 |
| 86 | Nb | Ag | 2 | 0.3 | 15 | Cr | Cu | 15 | 2.4 | 2.5 | -104 | 8.2 | 0.18 | 4000 |
| 87 | Nb | Ag | 2 | 0.3 | 15 | Mn | Cu | 15 | 2.4 | 2.5 | -104 | 8.1 | 0.18 | 4000 |
| 88 | Nb | Ag | 2 | 0.3 | 15 | Fe | Cu | 15 | 2.4 | 2.5 | -106 | 7.9 | 0.18 | 4000 |
| 89 | Nb | Ag | 2 | 0.3 | 15 | Co | Cu | 15 | 2.4 | 2.5 | -103 | 8.2 | 0.18 | 4000 |
| 90 | Nb | Ag | 2 | 0.2 | 10 | Ni | Cu | 15 | 2.4 | 2.5 | -48 | 8.5 | 0.21 | 4500 |

(continued)

| Sample No. | First to First Metal Layers 31,32 | Main Component of First Metal Layers 31, 32 | Each Thickness $t_4$ of Heat Conductive Layers 41, 42 (mm) | Each Thickness $t_5$ of Second Mental Layers 51.52 (mm) | Ratio $(t_5/t_4)$ (%) | Main Component of Intermediate Layers 61. 62 | Main Component of Second Metal Layers 51, 52 | Each Thickness $t_6$ of Intermediate layers 61. 62 ($\mu$m) | Total Area of Each Major Surface of Heat Conductive Layer 41 ($\times 10^3 mm^2$) | Area of Heat Conductive Layers 42 ($\times 10^3 mm^2$) | Warp ($\mu$m) | Peel Strength of Second Metal Layer 51 (kN/m) | Thermal Resistance (°C/W) | Cycle |
|---|---|---|---|---|---|---|---|---|---|---|---|---|---|---|
| 91 | Nb | Ag | 1 | 0.4 | 40 | - | Cu | - | 2.4 | 2.5 | -121 | 5.2 | 0.22 | 3000 |
| 92 | Nb | Ag | 1 | 0.3 | 30 | - | Cu | - | 2.4 | 2.5 | -102 | 5.9 | 0.24 | 3000 |
| 93 | Nb | Ag | 1 | 0.2 | 20 | - | Cu | - | 2.4 | 2.5 | -54 | 6.6 | 0.26 | 3500 |
| 94 | Nb | Ag | 2 | 0.3 | 15 | - | Cu | - | 2.4 | 2.5 | -127 | 6 | 0.16 | 3200 |
| 95 | Nb | Ag | 2 | 0.3 | 15 | Ni | Cu | 15 | 2.4 | 2.5 | -126 | 8.3 | 0.16 | 3500 |
| 96 | Nb | Ag | 1 | 0.3 | 30 | - | Cu | - | 2.4 | 2.5 | -128 | 6.1 | 0.2 | 3000 |
| *97 | Ti | Ag | - | 0.3 | | - | Cu | - | 2.2 | 2.5 | 141 | - | 0.39 | 3000 |
| *98 | Ti | Ag | - | 0.5 | | - | Cu | - | 2.2 | 2.5 | 203 | - | 0.31 | 3000 |

( * : Samples out of the scope of the present invention)
In Samples out of the scope of the present invention, t5 is thickness of copper plates 82. 83.
As to area, the copper plate 82 corresponds to the heat conductive layer 41, and the copper plate 83 corresponds to the heat conductive tayer 42.

As shown in Tables 1 to 4, it is found that Samples No. 97 and 98 serving as comparative examples have convex shapes warped toward the second major surface side and the absolute values of the warps are large.

On the other hand, since each of Samples No. 1 to 96 according to the present invention is formed by sequentially laminating, on the major surfaces of the support substrate 21 composed of a ceramics, from the support substrate 21 side, the first metal layers 31 and 32 containing at least one metal element selected from titanium, zirconium, hafnium, and niobium, the heat conductive layers 41 and 42 containing carbon as main components, and the second metal layers 51 and 52 containing copper as main components, the differences between the linear expansion coefficients of the support substrate 21 and the heat conductive layers 41 and 42 can be reduced. For this reason, it is found that a warp is concave toward the second major surface side and a small absolute value.

In particular, when Samples No. 5 to 7 having the second metal layers 51 and 52 whose the main components are different from each other are compared, it is found that, since Samples No. 5 and 6 include the first metal layers 31 and 32 containing silver or copper as main components and the second metal layers 51 and 52 contain copper or aluminum as main components, Samples No. 5 and 6 have low heat resistances and heat discharge characteristics better than that of Sample No. 7 having the second metal layers 51 and 52 that do not contain copper and aluminum as main components because both copper and aluminum have high heat conductivities.

When Samples No. 8 to 10 having the second metal layers 51 and 52 containing different main components are compared with each other, it is found that, since Samples 8 and 9 have the first metal layers 31 and 32 containing silver or copper as main components and the second metal layers 51 and 52 contain tungsten or molybdenum as main components, Samples No. 8 and 9 have warps occurring in the support substrate 21 smaller than that in Sample No. 10 having the second metal layers 51 and 52 that do not contain tungsten or molybdenum as main components, an electronic part such as a semiconductor element is mounted on any one of the second metal layers 51 and 52, and the reliability is not easily damaged by heat generated during an operation of the electronic part because differences between both the linear expansion coefficients of tungsten and molybdenum and both the linear expansion coefficients of a ceramics and carbon are small.

When Samples No. 2, 11, and 13 to 17 are compared with each other, it is found that, since Samples No. 11 and 13 to 17 have the intermediate layers 61 and 62 formed between the heat conductive layers 41 and 42 and the second metal layers 51 and 52 and containing, as main components, at least one metal element selected from chromium, manganese, iron, cobalt, and nickel. Samples No. 11 and 13 to 17 have peel strengths of the second metal layers 51 higher than that in Sample No. 2 in which the intermediate layer 61 is not formed and have bond strengths between the heat conductive layers 41 and the second metal layers 51 higher than that in Sample No. 2. For the same reason as described above, it can be argued that bond strengths between the heat conductive layers 42 and the second metal layers 52 in Sample No. 11 and 13 to 17 are high.

When Samples No. 19 to 21 are compared with each other, it is found that, since Samples 20 and 21 have the second metal layers 51 whose the thicknesses are 30% or less the thickness of the heat conductive layer 41, Samples No. 20 and 21 have warps occurring in the support substrates 21 smaller than that in Sample No. 19 having the second metal layers 51 whose the thicknesses are larger than 30% of the thicknesses of the heat conductive layers 41, an electronic part such as a semiconductor element is mounted on any one of the second metal layers 51 and 52, and the reliability is not easily damaged by heat generated during an operation of the electronic part because thermal stress generated in a bonding step due to the differences between the linear expansion coefficients of the heat conductive layers 41 and 42 and the second metal layers 51 and 52 decreases in Samples No. 20 and 21.

[Example 2]

Example 2 of the present invention will be described below by using the heat radiation base body 1 shown in FIG. 10.

In order to obtain the heat radiation base body 1 shown in FIG. 10, a paste-like brazing filler metal made of a silver-copper alloy containing a metal element shown in Table 5 was applied by screen printing on both the major surfaces of the support substrate 21 containing a silicon nitride as a main component and having a thickness of 0.32 mm.

The paste-like brazing filler metal are to form the first metal layers 31. and 32 after heating (will be described later), and metal elements in the first metal layers 31 and 32 and contents thereof are described in Table 5.

The heat conductive layers 41 and 42 made of carbonaceous sintered bodies each having a relative density of 90% and having a thickness of 2 mm were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 $\mu$m and to bond the support substrate 21 and the heat conductive layers 41 and 42 to each other.

The heat conductive layers 41 and 42 and the first metal layers 31 and 32 were patterned by electric discharge machining to have shapes shown in FIG. 10. Thereafter, the second metal layers 51 and 52 containing copper as main components were formed by a spraying method.

The support substrate 21 was cut by laser machining to obtain Samples No. 99 to 102 serving as the heat radiation base body 1 shown in FIG. 10 and in each of which the first metal layers 31 and 32, the heat conductive layers 41 and 42, and the second metal layers 51 and 52 were laminated on both the major surfaces of the support substrate 21 both the major surfaces of which have areas of $2.7 \times 10^3$ mm$^2$.

Areas of major surfaces of the heat conductive layers 42 in Samples No. 99 to 102 are $2.5 \times 10^3$ mm$^2$.

An area $S_v$ obtained by plane-viewing a void between the support substrate 21 and the first metal layers 31 and 32 was measured by ultrasonic inspection, and a ratio (= $S_v/S_o \times 100$) of the area $S_v$ to an area $S_o$ obtained when voids were not formed at all, i.e., an area obtained by adding the areas of the major surfaces of the heat conductive layers 41 and 42 bonded to the support substrate 21 was calculated and defined as a void ratio. As measurement conditions of the ultrasonic inspection, an inspection frequency, a gain, and a scanning pitch were set to 50 MHz, 30 dB, and 100 μm.

[Table 5]

| Sample No. | Metal Element contained in Silver-Copper alloy | | | First Metal Layers 31, 32 | | | | | | Void Ratio (area %) |
|---|---|---|---|---|---|---|---|---|---|---|
| | | | | Metal Element | Content (mass %) | Metal Element | Content (mass %) | Metal Element | Content (mass %) | |
| 99 | Ti | - | - | Ti | 2 | - | | - | - | 4 |
| 100 | Ti | In | - | Ti | 2 | In | 3 | - | - | 0.2 |
| 101 | Ti | Sn | - | Ti | 2 | Sn | 3 | - | - | 0.3 |
| 102 | Ti | In | Sn | Ti | 2 | In | 2 | Sn | 1 | 0.3 |

As shown in Table 5, in Samples No. 100 to 102, since the first metal layers 31 and 32 contain at least one metal element selected from indium and tin, the metal element has a melting point lower than another metal element constituting the first metal layers 31 and 32 and a more preferable wettability in bonding. For this reason, it is found that void ratios of Sample No. 100 to 102 are lower than that of Sample No. 99 and have reliability higher than the Sample No. 99.

[Example 3]

Example 3 of the present invention will be described below by using the heat radiation base bodys 1 shown in FIGS. 11, 13, and 14.

In order to obtain the heat radiation base bodys 1 shown in FIGS. 11, 13, and 14, on both the major surfaces of the support substrate 21 containing a silicon nitride as a main component and having a thickness of 0.32 mm, a paste-like brazing filler metal made of a silver-copper alloy containing titanium and indium was applied by screen printing.

The heat conductive layers 41 and 42 made of carbonaceous sintered bodies each having a relative density of 95% and having a thickness of 2 mm were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 μn and to bond the support substrate 21 and the heat conductive layers 41 and 42 to each other.

The first metal layers 31 and 32 and the heat conductive layers 41 and 42 were patterned by electric discharge machining to have shapes shown in FIGS. 11, 13, and 14.

With respect to Sample No. 104 to 108, a paste-like brazing filler metal made of a silver-copper alloy containing a metal element shown in Table 6 was applied to the side surfaces of the patterned first metal layers 31 and 32 and the patterned heat conductive layers 41 and 42 and heated at 800°C to form the covering layers 71 and 72. In Sample No. 103, no covering layers 71 and 72 were formed. On the heat conductive members 41 and 42 in Sample No. 103 to 108, by an electroless plating method, the intermediate layers 61 and 62 containing nickel as main components and each having a thickness of 15 μm were formed, and the second metal layers 51 and 52 containing copper as main components were formed on the intermediate layers 61 and 62 by a spraying method.

With respect to Sample No. 109 to 114, the intermediate layers 61 and 62 containing nickel as main components and each having a thickness of 15 μm were formed by an electroless plating method, and the second metal layers 51 and 52 containing copper as main components were formed on the intermediate layers 61 and 62 by a spraying method. The covering layers 71 and 72 containing a metal element shown in Table 7 were formed on the side surfaces of the first metal layers 31 and 32, the heat conductive layers 41 and 42, and the second metal layers 51 and 52 by an electroless plating method.

The support substrate 21 was cut by laser machining to obtain the heat radiation base bodys 1 shown in FIG. 11 (Sample No. 103), FIG. 13 (Samples No. 104 to 108), and FIG. 14 (Samples No. 109 to 114) in each of which the first metal layers 31 and 32, the heat conductive layers 41 and 42, and the second metal layers 51 and 52 were laminated on both the major surfaces of the support substrates 21 in each of which the areas of the major surfaces are 2.7 x 10$^3$ mm$^2$. The samples were dried in a constant-temperature vessel at 110°C $\pm$ 5°C and stood to be cooled in a desiccator, and the masses of the samples were measured. The obtained measurement value was defined as a dry mass $W_1$.

After the dry mass $W_1$ was measured, the samples were sunk under the water level of a boiling tank, boiled for 3 hours, and stood to be cooled to the room temperature. The samples were removed from the water, the surfaces of the samples were quickly wiped with wet gauze to remove waterdrops, and the masses of the samples were measured. The obtained measurement value was defined as a water saturation mass $W_2$.

A water absorption coefficient (W. A) was calculated by using the following equation (1), and the calculated value was shown in Tables 6 and 7.

$$W.A = (W_2 - W_1)/W_1 \times 100\ (\%) \qquad (1)$$

[Table 6]

| Sample No. | Metal Clement contained in Covering Layers 71,72 | Water Absorption Coefficient (%) |
|---|---|---|
| 103 | - | 5. 4 |
| 104 | Ti | 2, 2 |
| 105 | Zr | 2 |
| 106 | Hf | 2. 4 |
| 107 | Nb | 2. 6 |
| 108 | Ti, Zr | 2 |

[Table 7]

| Sample No. | Covering Layers formed on Side Surfaces of Heat Conducive Layers 41, 42 and Second Metal Layers 51, 52 | Water Absorption Coefficient (%) |
|---|---|---|
| 109 | Au | 1. 2 |
| 110 | Cu | 1. 3 |
| 111 | Al | 1 . 7 |
| 112 | Sn | 1. 3 |
| 113 | Zn | 0. 9 |
| 114 | Al, Zn | 0. 8 |

As shown in Tables 6 and 7, in Sample No. 104 to 108, the covering layers 71 and 72 made of a silver-copper alloy containing at least one metal element selected from titanium, zirconium, hafnium, and niobium are formed on the side surfaces of the heat conductive layers 41 and 42. For this reason, it can be argued that Samples No. 104 to 108 have water absorption coefficients (W. A) smaller than that of Sample No. 102 in which no covering layers 71 and 72 are formed and that moisture in the air is hard to be absorbed.

Furthermore, in Samples No. 109 to 114, the covering layers 71 and 72 containing at least one metal element selected from gold, copper, aluminum, tin, and zinc are formed on the side surfaces of the heat conductive layers 41 and 42 and the second metal layers 51 and 52. For this reason, it can be argued that Samples No. 109 to 114 have water absorption coefficients (W. A) smaller than those in Samples No.104 to 108 and that moisture in the air is more hard to be absorbed.

[Example 4]

Example 4 of the present invention will be described below by using the heat radiation base bodies 1 shown in

FIGS. 8 and 9.

In order to obtain the heat radiation base bodys 1 shown in FIGS. 8 and 9, on both the major surfaces of the support substrate 21 containing a silicon nitride as a main component and having a thickness of 0.32 mm, a paste-like brazing filler metal made of a silver-copper alloy containing titanium and indium was applied by screen printing.

The heat conductive layers 41 and 42 made of carbonaceous sintered bodies each having a relative density of 90% and having a thickness of 2 mm were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 $\mu$m and to bond the support substrate 21 and the heat conductive layers 41 and 42 to each other.

In this case, with respect to Sample No. 117, after the support substrate 21 was bonded to the heat conductive layers 41 and 42, the intermediate layers 61 and 62 each having a nickel content of 99% by weight and a thickness of 15 um were formed by an electroless plating method.

With respect to Samples No. 115 and 116, the second metal layers 51 and 52 containing copper as main components are formed on the heat conductive layers 41 and 42 by a thermal spray method. With respect to Sample No. 117, the second metal layers 51 and 52 containing copper as main components are formed on the intermediate layers 61 and 62 by a thermal spray method.

The support substrate 21 was cut by laser machining to obtain Samples No. 115 to 117 serving as the heat radiation base bodys 1 shown in FIGS. 8 and 9 and in each of which the first metal layers 31 and 32, the heat conductive layers 41 and 42, and the second metal layers 51 and 52 were laminated on both the major surfaces of the support substrate 21 both the major surfaces of which have areas of 2.7 x $10^3$ mm$^2$

Sample No. 115 is the heat radiation base body 1 that has the same basin shape as the shape shown in FIG. 8, but in which outer side surfaces of the first metal layers 31 and 32 and the heat conductive layers 41 and 42 are on the same line as that of the support substrate 21.

The heat cycle test described in Example 1 was performed to examine the number of cycles of cracks confirmed for the first time in the support substrate 21 by the method described, in Example 1. The number of cycles is shown in Table 8.

[Table 8]

| Sample No. | Target Figure No. of Sample | Cycle |
|---|---|---|
| 115 | FIG. 8 | 3000 |
| 116 | FIG. 8 | 3500 |
| 117 | FIG. 9 | 4000 |
| Sample No. 115 is the heat radiation base body 1 that has the same basic shape as the shape shown in FIG. 8, but in which outer side surfaces of the first metal layers 31 and 32 and the heat conductive layers 41 and 42 are on the same line as that of the support substrate 21. | | |

As shown in Table 8, in Samples No. 116 and 117, since the outer side surfaces of the first metal layers 31 and 32 and the heat conductive layers 41 and 42 are on the inside of the side surface of the support substrate 21, the side surfaces of the heat conductive layers 41 and 42 and the second metal layers 51 and 52 are restrained strongly more than those in Sample No. 115 in which outer side surfaces of the first metal layers 31 and 32 and the heat conductive layers 41 and 42 are on the same line as that of the side surface of the support substrate 21. For this reason, the heat conductive layers 41 and 42 and the second metal layers 51 and 52 are not easily deformed, and stress occurring in the support substrate 21 is suppressed due to heat generated during an operation of an electronic part. Thus, it is found that cracks do not easily occur and that the reliability is high.

[Example 5]

Example 5 of the present invention will be described below by using the heat radiation base bodys 1 shown in FIGS. 8 and 10.

In order to obtain the heat radiation base bodys 1 shown in FIGS. 8 and 10, on both the major surfaces of the support substrate 21 containing a silicon nitride as a main component and having a thickness of 0.32 mm, a paste-like brazing filler metal made of a silver-copper alloy containing titanium and indium was applied by screen printing.

The heat conductive layers 41 and 42 made of carbonaceous sintered bodies each having a relative density of 90% and having a thickness of 2 mm were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 μm and to bond the support substrate 21 and the heat conductive layers 41 and 42 to each other.

With respect to Samples No. 118 and 119, the first metal layers 31 and 32 and the heat conductive layers 41 and 42 were patterned by electric discharge machining to have shapes shown in FIG. 8. With respect to Sample No. 120, the first metal layers 31 and 32 and the heat conductive layers 41 and 42 were patterend by electric discharge machining to have shapes shown in FIG. 10. Thereafter, the second metal layers 51 and 52 containing copper as main components were formed by a spraying method.

The support substrate 21 was cut by laser machining to obtain Samples No. 118 to 120 serving as the heat radiation base bodys 1 shown in FIGS. 8 and 10 and in each of which the first metal layers 31 and 32, the heat conductive layers 41 and 42, and the second metal layers 51 and 52 were laminated on both the major surfaces of the support substrate 21 whose both the major surfaces have areas of $2.7 \times 10^3$ mm$^2$.

Sample No. 118 is the heat radiation base body 1 that has the same basic shape as the shape shown in FIG. 8, but in which the heat conductive layer 42 arranged on the second major surface side has a projection area in a plane view that is equal to a projection area of the heat conductive layer 41 arranged on the first major surface side.

A simulation was performed on the supposition that an amount of heat of $5.2 \times 10^5$ W/m$^2$ was given to the major surfaces of the second metal layer 51 per unit area to estimate heat resistances of the samples. The estimate values are shown in Table 9.

[Table 9]

| Sample No. | Target Figure No. of Sample | Heat Resistance (°C/W) |
|---|---|---|
| 118 | FIG. 8 | 0.25 |
| 119 | FIG. 8 | 0.21 |
| 120 | FIG. 10 | 0.22 |
| Sample No. 118 is the heat radiation base body 1 that has the same basic shape as the shape shown in FIG. 8, but in which the heat conductive layer 42 arranged on the second major surface side has a projection area in a plane view that is equal to a projection area of the heat conductive layer 41 arranged on the first major surface side. | | |

As shown in Table 9, in Samples No. 120 and 121, since a planarly-viewed projection area of the heat conductive layer 42 arranged on the second major surface side is larger than a projection area of the heat conductive layer 41 arranged on the first major surface side, heat resistances are lower than those in Sample No. 119 in which the planarly-viewed projection area of the heat conductive layer 42 is equal to the projection area of the heat conductive layer 41. It can be argued that an electronic part is mounted on the first major surface side and that heat generated from the electronic part is efficiently diffused and estimated to be discharged to obtain a good heat discharge characteristic.

In particular, in Sample No. 121, the heat conductive layer 42 arranged on the second major surface side is configured by a single layer and formed to have a size larger than that of the heat conductive layer 41 arranged on the first major surface side. Thus, it is found that the heat discharge characteristic is good.

[Example 6]

Example 6 of the present invention will be described below by using the heat radiation base body 1 shown in FIGS. 13, 15, and 16.

In order to obtain the heat radiation base body 1 shown in FIGS. 13, 15, and 16, on both the major surfaces of the support substrate 21 containing a silicon nitride as a main component and having a thickness of 0.32 mm, a paste-like brazing filler metal made of a silver-copper alloy containing titanium and indium was applied by screen printing.

The heat conductive layers 41 and 42 made of carbonaceous sintered bodies each having a relative density of 90% and having a thickness of 2 mm were formed on both the sides of the support substrate 21 through the paste-like brazing filler metal and heated to 850°C in a vacuum atmosphere having an ultimate vacuum of $10^{-2}$ Pa or less to form the first metal layers 31 and 32 each having a thickness of 10 μm and to bond the support substrate 21 and the heat conductive layers 41 and 42 to each other.

The first metal layers 31 and 32 and the heat conductive layers 41 and 42 were patterned by electric discharge machining to have shapes shown in FIGS. 13, 15, and 16.

After the intermediate layers 61 and 62 each having a nickel content of 99% by weight and a thickness of 15 μm were formed by an electroless plating method, the second metal layers 51 and 52 containing copper as main components were formed on the intermediate layers 61 and 62 by a thermal spray method.

The covering layers 71 and 72 made of copper was formed on the side surfaces of the patterned first metal layers 31 and 32 and the patterned heat conductive layers 41 and 42 by an electroless plating method.

The support substrate 21 was cut by laser machining to obtain Samples No. 121 to 123 serving as the heat radiation base bodys 1 shown in FIGS. 13, 15, and 16 and in each of which the first metal layers 31 and 32, the heat conductive layers 41 and 42, and the second metal layers 51 and 52 were laminated on both the major surfaces of the support substrate 21 both the major surfaces of which have areas of $2.7 \times 10^3$ mm$^2$.

The heat cycle test described in Example 1 was performed to examine the number of cycles when cracks were confirmed for the first time in the support substrate 21 by the method described in Example 1. The number of cycles is shown in Table 10.

[Table 10]

| Sample No. | Target Figure No. Samples | of Cycle |
|---|---|---|
| 121 | FIG. 13 | 3000 |
| 122 | FIG. 15 (Inclination) | 3500 |
| 123 | FIG. 16 (Step) | 3500 |

As shown in Table 10, in Sample No. 122, since at least a part on the side surface of the heat conductive layer 41 arranged on the first major surface side or the side surface of the heat conductive layer 42 arranged on the second major surface side is inclined outward toward the support substrate 21, a heat exchange from the first major surface side to the second major surface side more rapidly progresses. For this reason, it is found that, in comparison with Sample No. 121 in which the side surfaces of the heat conductive layers 41 and 42 are not inclined outward toward the support substrate 21, cracks are more hard to occur, and high reliability can be obtained.

In Sample No. 123, since at least a part on the side surface of the heat conductive layer 41 arranged on the first major surface side or the side surface of the heat conductive layer 42 arranged on the second major surface side has a step spreading outward on the side of the support substrate 21, a heat exchange from the first major surface side to the second major surface side more rapidly progresses. For this reason, it is found that, in comparison with Sample No. 121 in which the side surfaces of the heat conductive layers 41 and 42 do not have a step spreading outside the support substrate 21, cracks are more hard to occur, and high reliability can be obtained.

[Example 7]

Samples No. 124 to 128 of the support substrates 21 made of a ceramics containing a silicon nitride, an aluminum nitride, an aluminum oxide, a beryllium oxide, or a zirconium oxide as main components were manufactured, and, in conformity to JIS R 1611 - 1997 and JIS R 1601 - 2008 (ISO 17565:2003 (MOD)), heat conductivities and three-point bending strengths of the samples were measured. The measurement values are shown in Table 11.

[Table 11]

| Sample No. | Main Component of Support Substrate | Heat Conductivity (W/(m·K)) | Three-Point Blending Strength (MPa) |
|---|---|---|---|
| 124 | $Si_3N_4$ | 58 | 820 |
| 125 | AlN | 150 | 310 |
| 126 | $Al_2O_3$ | 34 | 380 |
| 127 | BeO | 280 | 241 |
| 128 | $ZrO_2$ | 3 | 1470 |

As shown in Table 11, in Samples No. 124 to 126, since the support substrates 21 made of ceramics containing a silicon nitride, an aluminum nitride, and an aluminum oxide as main components, heat conductivities are 34 W/(m·K) or more, and three-point bending strengths are 310 MPa or more. It is found that Samples No. 124 to 126 satisfy thermal and mechanical characteristics required for the support substrate 21 of the heat radiation base body 1. Reference Numerals

| | |
|---|---|
| 1: | Heat radiation base body |
| 21: | Support substrate |
| 31, 32: | First metal layer |
| 41, 42: | Heat conductive layer |
| 51, 52: | Second metal layer |
| 61, 62: | Intermediate layer |
| 71, 72: | Covering layer |

**Claims**

1. A heat radiation base body wherein a first metal layer containing at least one metal element selected from titanium, zirconium, hafnium, and niobium; a heat conductive layer containing carbon as a main component; and a second metal layer are sequentially laminated on at least one major surface of a support substrate composed of a ceramics from the support substrate side.

2. The heat radiation base body according to claim 1, wherein the first metal layer contains copper as a main component, and the second metal layer contains silver or copper as a main component.

3. The heat radiation base body according to claim 1, wherein the first metal layer contains silver as a main component, and the second metal layer contains copper or aluminum as a main component.

4. The heat radiation base body according to claim 1, wherein the first metal layer contains silver or copper as a main component, and the second metal layer contains tungsten or molybdenum as a main component.

5. The heat radiation base body according to claim 1, wherein the first metal layer contains at least one metal element selected from indium and tin.

6. The heat radiation base body according to claim 1, wherein the first metal layer contains silver or copper as a main component and contains at least one metal element selected from indium and tin.

7. The heat radiation base body according to claim 1, wherein an intermediate layer is formed at least one of between the heat conductive layer and the first metal layer and between the heat conductive layer and the second metal layer, and the intermediate layer contains, as a main component, at least one metal element selected from chromium, manganese, iron, cobalt, and nickel.

8. The heat radiation base body according to claim 1, wherein a covering layer composed of a silver-copper alloy which contains at least one metal element selected from titanium, zirconium, hafnium and niobium is formed on a side surface of the heat conductive layer,.

9. The heat radiation base body according to claim 1, wherein a covering layer composed of at least one metal element selected from gold, copper, aluminum, tin, and zinc are formed on the side surfaces of the heat conductive layer and the second metal layer.

10. The heat radiation base body according to claim 1, wherein a thickness of the second metal layer is 30% or less of a thickness of the heat conductive layer.

11. The heat radiation base body according to claim 1, wherein the first metal layer and the heat conductive layer have outer side surfaces that are on the inside of a side surface of the support substrate.

12. The heat radiation base body according to claim 1,
wherein the first metal layer, the heat conductive layer, and the second metal layer are sequentially laminated on a first major surface of the support substrate and a second major surface on a backside of the first major surface, respectively, from the side of the support substrate,
the heat radiation base body is configured to mount a plurality of electronic parts on the first major surface side,
the heat conductive layer arranged on the first major surface side is divided into a plurality of parts which is configured to be electrically independently connected to the electronic parts, and
the heat conductive layer arranged on the second major surface side has a projection area of a perspective plane view that is larger than a projection area of a perspective plane view which the heat conductive layer arranged on the first major surface side has.

13. The heat radiation base body according to claim 1, wherein the heat conductive layer arranged on the second major surface side is a single layer.

14. The heat radiation base body according to claim 1, wherein at least a part on a side surface of the heat conductive layer arranged on the first major surface side or a side surface of the heat conductive layer arranged on the second major surface side is inclined outward toward the support substrate.

15. The heat radiation base body according to claim 1, wherein at least a part on a side surface of the heat conductive layer arranged on the first major surface side or a side surface of the heat conductive layer arranged on the second major surface side has a step spreading outward on the side of the support substrate.

16. The heat radiation base body according to claim 1, wherein the support substrate is composed of a ceramics which contains a silicon nitride, an aluminum nitride, or an aluminum oxide as a main component.

17. An electronic device wherein an electronic part is mounted on the second metal layer arranged on the first major surface side in the heat radiation base body according to claim 1.

Fig.1

(a)

X

Y

1

21
51
42

A          A

(b)

51
41
31
32
42
52

1

21

Fig.2

Fig.3

(a)

(b)

Fig.4

(a)

X

Y

1

71
51
42

21
72

C                                                    C

(b)

51
61
71
41
31
32
42
72
62
52

1

21

Fig.5

Fig.6

Fig.7

# Fig.8

(a)

(b)

(c)

Fig.9

(a)

1

X

Y

21

51

H

H

(b)

1

51
61
41
31

21

32
42
62
52

(c)

1

21

52

Fig.10

(a)

(b)

(c)

Fig.11

(a)

(b)

(c)

# Fig.12

(a)

(b)

(c)

## Fig.13

(a)

(b)

(c)

## Fig.14

(a)

(b)

(c)

Fig.15

(a)

(b)

(c)

# Fig.16

(a)

(b)

(c)

Fig.17

<table>
<tr><td colspan="2" align="center">**INTERNATIONAL SEARCH REPORT**</td><td>International application No.<br>PCT/JP2010/051211</td></tr>
</table>

A. CLASSIFICATION OF SUBJECT MATTER
*H01L23/36*(2006.01)i, *H01L23/13*(2006.01)i, *H05K7/20*(2006.01)i

According to International Patent Classification (IPC) or to both national classification and IPC

B. FIELDS SEARCHED

Minimum documentation searched (classification system followed by classification symbols)
H01L23/36, H01L23/13, H05K7/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y<br>A | JP 2009-4666 A (Hitachi, Ltd.),<br>08 January 2009 (08.01.2009),<br>paragraphs [0024] to [0034], [0057] to [0063];<br>fig. 1<br>& US 2008/0315401 A1 | 1,3,5,7,10,<br>11,16-17<br>2,6<br>4,8-9,12-15 |
| Y | JP 60-26633 A (Hitachi, Ltd.),<br>09 February 1985 (09.02.1985),<br>entire text<br>(Family: none) | 2,6 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>23 March, 2010 (23.03.10) | Date of mailing of the international search report<br>30 March, 2010 (30.03.10) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 393 110 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5090444 A

- JP 5148053 A